# EUROPEAN PATENT APPLICATION

(11) **EP 4 485 134 A1**
(43) Date of publication of application: **01.01.2025**
(21) Application number: 23214733.0
(22) Date of filing: 06.12.2023
(51) Int. Cl.: G06F 1/20, H05K 1/02, H05K 7/20

(54) **COLD PLATES FOR SECONDARY SIDE COMPONENTS OF PRINTED CIRCUIT BOARDS**

(30) Priority: 29.06.2023 US 202318344308
(71) Applicant: Intel Corporation, Santa Clara, CA 95054 (US)
(72) Inventor: SUBRAHMANYAM, Prabhakar, San Jose, 95126 (US); SHAH, Tejas J., Austin, 78727 (US); XIA, Yi, Campbell, 95008 (US); PANG, Ying-Feng, San Jose, 95131 (US); BIANCO, Mark Lawrence, Mountain View, 94043 (US); SUGUMAR, Vishnu Prasadh, Santa Clara, 95054 (US); RAO, Vikas Kundapura, 560103 Bangalore (IN); DAMARAJU, Srinivasa Rao, Fremont, 94538 (US); SAHAN, Ridvan Amir, Sunnyvale, 94087 (US); AL-MOMANI, Emad Shehadeh, Austin, 78749 (US); MOHAMMED, Rahima Khatun, 95135 San Jose (DE); WANG, Mirui, Portland, 97229 (US); KULKARNI, Devdatta Prakash, Portland, 97229 (US)
(74) Representative: Maiwald GmbH

(57) **Abstract**

Cold plates for secondary side components of printed circuit boards are disclosed herein. An example apparatus disclosed herein includes a first printed circuit board, a second printed circuit board coupled to the first printed circuit board, the second printed circuit board having a first side and a second side opposite the first side, the second side facing the first printed circuit board, and a cold plate coupled to the second side of the second printed circuit board.

## Description

### FIELD OF THE DISCLOSURE

This disclosure relates generally to compute components and, more particularly, to cold plates for secondary side components of printed circuit boards.

### BACKGROUND

The use of liquids to cool electronic components is being explored for its benefits over more traditional air cooling systems, as there is an increasing need to address thermal management risks resulting from increased thermal design power in high-performance systems (e.g., CPU and/or GPU servers in data centers, cloud computing, edge computing, and the like). More particularly, relative to the air, liquid has inherent advantages of higher specific heat (when no boiling is involved) and higher latent heat of vaporization (when boiling is involved).

### BRIEF DESCRIPTION OF THE DRAWINGS

FIG. 1A is a front view of a printed circuit board assembly in which the teachings of this disclosure can be implemented.
FIG. 1B is a rear view of the printed circuit board assembly of FIG. 1A.
FIG. 2 is a side view of the printed circuit board assembly of FIGS. 1A and 1B.
FIG. 3A is a front view of an example first cold plate coupled to the secondary side of the printed circuit board of FIGS. 1A-2.
FIG. 3B is a front view of an example second cold plate coupled to the secondary side of the printed circuit board of FIGS. 1A-2.
FIG. 4 is a side view of an example first assembly including the printed circuit board of FIGS. 1A-3B, a primary side cold plate, and a secondary side cold plate.
FIG. 5 is a side view of an example second assembly including the printed circuit board of FIGS. 1A-3B, a primary side cold plate, and a secondary side cold plate.
FIG. 6 is a perspective view of an example array including the first assembly of FIG. 4.
FIG. 7 is a perspective view of another example array including the second assembly of FIG. 5.
FIG. 8 is a bottom perspective view of another example secondary side cold plate assembly coupled to a printed circuit board.
FIG. 9 is a bottom perspective exploded view of the secondary side cold plate assembly of FIG. 8.
FIG. 10 is a side exploded view of the secondary side cold plate assembly of FIGS. 8 and 9.
FIG. 11 is a perspective view of the printed circuit board of FIGS. 8-10.
FIG. 12 is a perspective view of a stiffener of the secondary side cold plate assembly of FIGS. 8-10.
FIG. 13 is a perspective view of a cold plate housing of the secondary side cold plate assembly of FIGS. 8-10.
FIGS. 14A and 14B are schematic diagrams illustrating the coupling of the cold plate housing of FIGS. 8-10 and 13 and an example top fin plate.
FIG. 15 illustrates of a plurality of fin configurations that can be used with the top fin plate of FIG. 14 and/or the cold plate housing of FIG. 13.
FIG. 16 is a perspective view of the cold plate housing of FIG. 13 and illustrates an example internal wall structure.
FIG. 17 is a top perspective view of the secondary side cold plate assembly of FIGS. 8-10.
FIG. 18 is a top perspective example view of the secondary side cold plate assembly of FIGS. 8-10 and 17.
FIG. 19A is a schematic diagram of the secondary side cold plate assembly of FIGS. 8-10 and 17 including a stiffener plate with blind holes.
FIG. 19B is a schematic diagram of the secondary side cold plate assembly of FIGS. 8-10 and 17 including a stiffener plate with through holes.
FIG. 19C is a schematic diagram of the secondary side cold plate assembly of FIGS. 8-10 and 17 including a stiffener plate with through holes and pedestals.
FIG. 20 is a perspective view of an example dual-sided cold plate assembly in accordance with the teachings of this disclosure.
FIG. 21 is a perspective view of an array of printed circuit boards including the dual-sided cold plate assembly of FIG. 20.
FIG. 22 is a schematic diagram of another cooling assembly coupled to a printed circuit board in accordance with the teachings of this disclosure.
FIG. 23 is a perspective view of another secondary side cold plate cooling assembly in accordance with the teachings of this disclosure.
FIG. 24 is a perspective exploded view of the secondary side cold plate of FIG. 23.
FIG. 25 is a perspective exploded view of an example secondary side heat sink implemented in accordance with the teachings of this disclosure.
FIG. 26 is a schematic diagram of an alternative stiffener plate that can be used with the example secondary cold plate assemblies of FIGS. 8, 9, 17, 18, 19A, 19B, and/or 22.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

### DETAILED DESCRIPTION

As noted above, the use of liquids to cool electronic components is being explored for its benefits over more traditional air cooling systems, as there are increasing needs to address thermal management risks resulting from increased thermal design power in high-performance systems (e.g., CPU and/or GPU servers in data centers, accelerators, artificial intelligence computing, machine learning computing, cloud computing, edge computing, and the like). More particularly, relative to air, liquid has inherent advantages of higher specific heat (when no boiling is involved) and higher latent heat of vaporization (when boiling is involved). In some instances, liquid can be used to indirectly cool electronic components by cooling a cold plate that is thermally coupled to the electronic component(s).

In recent years, cold plate-based liquid-cooling systems have become more commonly used in compute systems. Cold plate systems facilitate the cooling of compute components via conduction between a heat-producing component, such as a processor, and a cold plate that is located proximate to the heat-producing component and is cooled via the flow of a liquid coolant therethrough. Coolant is cycled through the cold plate to provide for heat transfer from the heat-producing component to the coolant. Thus, liquid can be used to indirectly cool electronic components by cooling a cold plate that is thermally coupled to the electronic component(s).

In recent years, the heat output of integrated circuit package(s) coupled to a printed circuit board has increased such that additional cooling efforts at the printed circuit boards may be warranted to maintain or increase the performance capabilities of the integrated circuit package(s). As used herein, a printed circuit board includes a first or primary side to which, for instance, integrated circuit package(s) are coupled and a secondary side opposite the primary side. A stiffener (e.g., a plate) may be coupled to the secondary side of the printed circuit board to provide structural support to a substrate of the printed circuitry by, for instance, deflecting stresses experienced by the printed circuit board. Packaging space constraints may limit the size of cooling system(s) that can be carried by a printed circuit board. For example, a printed circuit board supporting an integrated circuit package may be coupled to a baseboard that includes other printed circuit boards. The secondary side of the printed circuit board typically faces the baseboard. As noted above, a stiffener may be coupled to the second side of the printed circuit board, which further affects access to the secondary side of the printed circuit board. Also, the printed circuit board may include thermally insulative materials (e.g., glass, reinforced plastics, etc.) that can affect the efficiency of cooling at the printed circuit board and, in particular, efforts to provide cooling via the secondary side of the printed circuit board.

Examples disclosed herein include cooling systems that provide for cooling via the secondary side of the printed circuit board. Examples disclosed herein include cold plate(s) carried by (e.g., disposed in, integrated with) a stiffener coupled to the secondary side of a printed circuit board. In some such examples disclosed herein, the secondary side cold plate(s) are arranged in parallel with cold plate(s) disposed on the primary side of the printed circuit board. In other examples disclosed herein, the secondary side cold plate(s) are arranged in sequence with cold plate(s) on the primary side of the printed circuit boards. In some examples disclosed herein, stiffener plate includes opening(s) defined therein (e.g., cutout(s)) to receive heat-producing electronic component(s) and/or portion(s) thereof of the printed circuit board. In some such examples disclosed herein, the cutouts enable the heat-producing components of the printed circuit boards to abut the secondary side cold plates. In some examples disclosed herein, the secondary side cold plates include fin structures, channels, and/or internal walls to increase the internal surface area of the cold plate exposed to the flow of coolant. Examples disclosed herein provide for additional cooling at the printed circuit board via the secondary side of the printed circuit board, which can reduce a size of the cooling system(s) (e.g., cold plate(s)) provided on the primary side of printed circuit boards. Further, examples disclosed herein increase the total cooling capability achieved at the printed circuit board, which can enable more powerful processing performance by the electronic component(s) of the printed circuit boards.

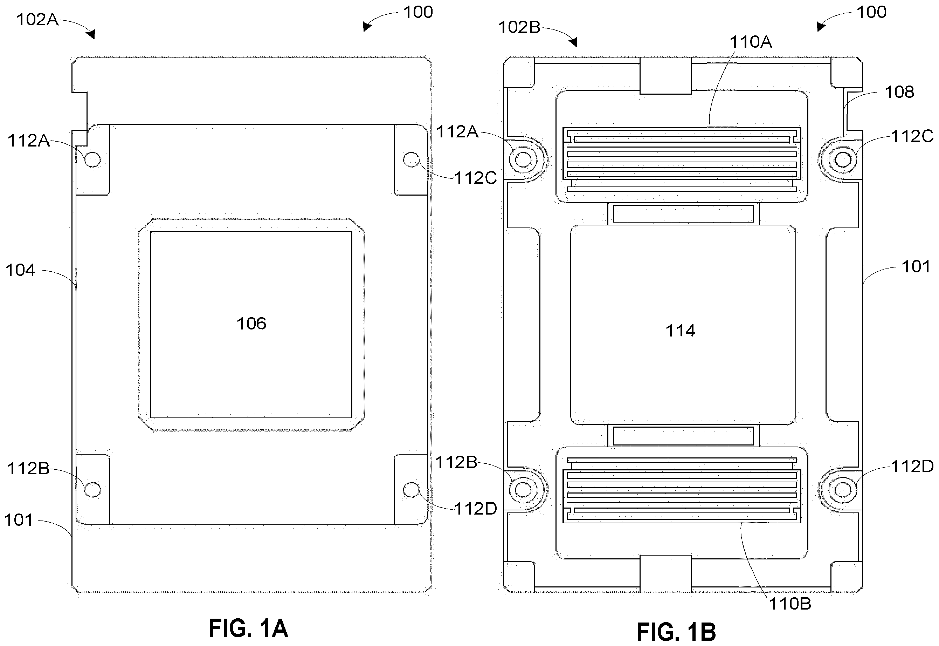

FIG. 1A and FIG. 1B are a front view and a rear view, respectively, of an example printed circuit board assembly 100 in which the teachings of this disclosure can be implemented. In the illustrated example of FIGS. 1A and 1B, the printed circuit board assembly 100 includes an example printed circuit board (PCB) 101 (e.g., a substrate), which has an example primary side 102A and an example secondary side 102B. In the illustrated example of FIG. 1A, the primary side 102A of the printed circuit board 101 includes an example first stiffener 104 and an example die 106. In the illustrated example of FIG. 1B, the secondary side 102B of the printed circuit board 101 includes an example second stiffener 108, an example first connector 110A, and an example second connector 110B. In the illustrated example of FIGS. 1A and 1B, the printed circuit board assembly 100 includes an example first aperture 112A, an example second aperture 112B, an example third aperture 112C, and an example fourth aperture 112D.

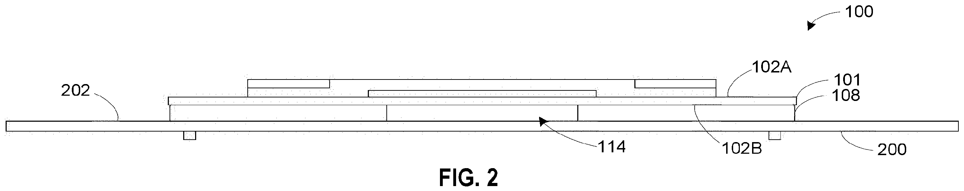

The example printed circuit board assembly 100 of FIGS. 1A and 1B has an open core protocol (OCP) accelerator module (OAM) form factor. The printed circuit board assembly 100 of FIGS. 1A and 1B can have any other form factor (e.g., a peripheral component interconnect express (PCIe) card electromechanical (CEM) form factor, a PCIe M.2 form factor, a PCIe U.2 form factor, etc.). The printed circuit board assembly 100 can be a component of an accelerator (e.g., a graphics processor unit (GPU), etc.) and/or another compute component. In some such examples, the printed circuit board assembly 100 can be coupled to another PCB (e.g., a baseboard, a motherboard, etc.). An example coupling between the printed circuit board assembly 100 of FIGS. 1A and 1B and another PCB is disclosed below in connection with FIG. 2.

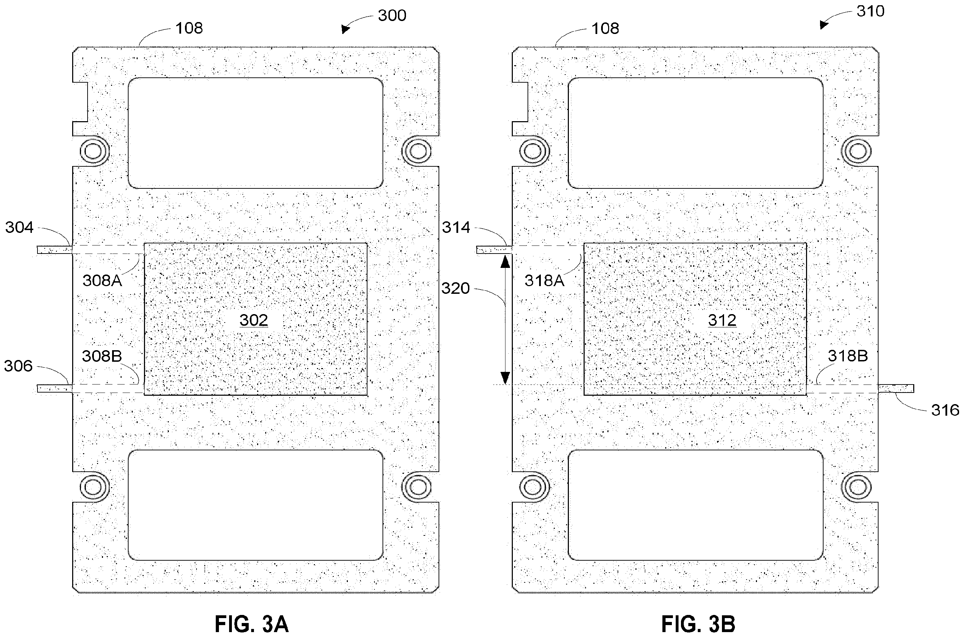

The first stiffener 104 and the second stiffener 108 are mechanical components (e.g., plates, etc.) of the printed circuit board assembly 100 that mitigate the deformation of the printed circuit board 101 (e.g., caused by the coupling of the printed circuit board assembly 100 to another PCB, caused by the coupling a heat sink and/or cold plate the primary side 102A of the printed circuit board 101, etc.). The stiffeners 104, 108 can be composed of any suitable material with a suitably high elastic modulus (e.g., steel, reinforced plastic, aluminum, etc.). In the illustrated example of FIG. 1B, the secondary side 102B of the printed circuit board 101 includes an example region 114 defined by the second stiffener 108 and the printed circuit board 101. Example cold plates disposed in the region 114 of the second stiffener 108 are described below in conjunction with FIGS. 3A and 3B.

The die 106 is a portion of semiconductor material disposed on the primary side of the printed circuit board 101. In the illustrated example of FIG. 1A, the printed circuit board assembly 100 has a single die (e.g., the die 106, etc.). In other examples, the printed circuit board assembly 100 can include multiple dies. In some such examples, the stiffeners 104, 108 can have different shapes and/or sizes to accommodate the additional dies. In some examples, a compute unit (e.g., a processor, an application specific integrated circuit (ASIC), etc.) can be formed on or supported by the die 106. The die 106 and/or the integrated circuits supported thereon are heat-generating components, which generate heat during the operation of the printed circuit board assembly 100. In the illustrated examples of FIG. 1A and 1B, the die 106 is aligned or substantially aligned with the region 114 of the secondary side 102B. To prevent overheating of the electronic components of the printed circuit board assembly 100, heat dissipating systems can be coupled to the primary side 102A and/or the secondary side 102B of the printed circuit board 101 (e.g., in the region 114, etc.). Example heat dissipating components are disclosed below in conjunction with FIGS. 3A-26.

The connectors 110A, 110B are PCB-to-PCB connectors that enable the printed circuit board assembly 100 to be coupled to another PCB. In the illustrated example of FIG. 1B, the connectors 110A, 110B are mezzanine connectors. The connectors 110A, 110B can be any other suitable type of connectors. In some examples, one or both of the connectors 110A, 110B are absent. In the illustrated example of FIGS. 1A and 1B, the apertures 112A, 112B, 112C, 112D of the printed circuit board assembly 100 are through holes that extend through the printed circuit board 101, the first stiffener 104, and the second stiffener 108. In some examples, one or more fasteners (not illustrated) can extend through corresponding ones of the apertures 112A, 112B, 112C, 112D to retain a heat sink and/or a cold plate to the primary side 102A of the printed circuit board assembly 100. In other examples, one or more of the apertures 112A, 112B, 112C, 112D can be absent.

FIG. 2 is a side view of the printed circuit board assembly 100 of FIGS. 1A and 1B and example baseboard 200. The baseboard 200 is a PCB that can receive one or more other PCBs, including the printed circuit board 101 of FIGS. 1A and 1B. In some examples, the baseboard 200 is a universal baseboard (UBB) and/or a motherboard (MB). In other examples, the baseboard 200 can be implemented by another suitable type of PCB. In the illustrated example of FIG. 2, the printed circuit board assembly 100 is coupled to a first (e.g., top) surface 202 of the baseboard 200. In the illustrated example of FIG. 2, the example primary side 102A of the printed circuit board 101 is oriented away from the baseboard 200 and the example secondary side 102B of the printed circuit board 101 is oriented toward the baseboard 200. In some examples, the connectors 110A, 110B of FIG. 1B can be coupled to corresponding connectors of the baseboard 200. In other examples, the baseboard 200 and the printed circuit board assembly 100 can be coupled in any other suitable manner. In the illustrated example of FIG. 2, the example second stiffener 108 at least partially abuts (e.g., directly contacts) the baseboard 200. As described above in connection with FIGS. 1A and 1B, the region 114 is defined relative to the second stiffener 108. In particular, the region 114 of the second stiffener 108 is defined by the interior walls of the second stiffener 108, the secondary side 102B of the printed circuit board 101, and the top surface 202 of the baseboard 200.

FIG. 3A is a front view of an example first stiffener subassembly 300 that can be used in connection with the printed circuit board assembly 100 of FIGS. 1A-2. In some examples, the first stiffener subassembly 300 can be used to implement the second stiffener 108 of FIGS. 1B and 2. In the illustrated example of FIG. 3A, an example cold plate 302 is disposed in the example region 114 (FIG. 1B) of the second stiffener 108. In the illustrated example of FIG. 3A, the example first cold plate 302 includes a cold plate inlet 304 and a cold plate outlet 306.

The first cold plate 302 is a thermo-mechanical structure that dissipates heat from the secondary side 102B of the printed circuit board 101 (e.g., heat generated by the integrated circuit formed on the die 106 of FIG. 1A, etc.). In some examples, the first cold plate 302 is comparatively smaller than heat-dissipating structure(s) (e.g., heat sinks, cold plates, etc.) that can be coupled to the primary side 102A of the printed circuit board 101 based on, for instance, the size of the region 114. In some examples, the first cold plate 302 can be composed of any suitable thermally conductive material (e.g., copper, aluminum, brass, silver, etc.). In some examples, the first cold plate 302 can be manufactured via additive manufacturing. Additionally or alternatively, the first cold plate 302 can be manufactured in any other suitable manner (e.g., casting, machining, etc.). In some examples, a thermally conductive paste can be disposed on the secondary side 102B of the region 114 to improve the rate of conduction therebetween.

In some examples, the first cold plate 302 can be coupled to the second stiffener 108 via one or more fasteners. Additionally or alternatively, the first cold plate 302 can be coupled to the second stiffener 108 via one more welds, one or more chemical adhesives, one or more press fits, one or more shrink fits, etc. In some examples, the first cold plate 302 can be retained with the first stiffener subassembly 300 via the abutment of the second stiffener 108, the baseboard 200 of FIG. 2, and the printed circuit board 101 of FIGS. 1A and 1B. In some examples, the first cold plate 302 can be integrally formed with the second stiffener 108.

In the illustrated example of FIG. 3A, the cold plate inlet 304 and the cold plate outlet 306 are disposed on a same side of the second stiffener 108. In the illustrated example of FIG. 3A, the second stiffener 108 includes an example first aperture 308A and an example second aperture 308B through which the cold plate inlet 304 and the cold plate outlet 306, respectively, extend to fluidly couple with the cold plate 302. In other examples, one or both of the cold plate inlet 304 and the cold plate outlet 306 can extend through a channel formed in the walls of the second stiffener 108. The cold plate inlet 304 and the cold plate outlet 306 define an example coolant pathway through which coolant can flow through the first cold plate 302. In other examples, the first cold plate 302 can have multiple inlets and outlets in addition to the cold plate inlet 304 and the cold plate outlet 306. In some such examples, each pair of inlets and outlets can define a corresponding coolant pathway through the first cold plate 302.

During the operation of electronic component(s) carried by the printed circuit board assembly 100 (e.g., the integrated circuit formed on the die 106 of FIG. 1A), the first cold plate 302 absorbs heat generated by the electronic component(s) via conduction. To facilitate cooling, a coolant flows from a coolant source into the first cold plate 302 via the cold plate inlet 304, absorbs heat from the body of the first cold plate 302 as the coolant flow through an internal flow path of the first cold plate 302, and leaves the first cold plate 302 via the cold plate outlet 306. The coolant can include ammonia, methanol, ethanol, water, mercury, hydrofluorocarbon refrigerants hydrocarbons (e.g., mineral oil, hexane, castor oil, etc.), acetone, esters, and/or an electrically insulative coolant (e.g., fluorinated ketones, per-fluorinated compounds, etc.), benzene, etc. In some examples, the coolant flowing through the first cold plate 302 can vaporize. In other examples, the coolant flowing through the first cold plate 302 can remain in a liquid phase. In some examples, the first cold plate 302 can include channels (e.g., a microchannel structure) defined between the cold plate inlet 304 and the cold plate outlet 306 through which the coolant flows. Additionally or alternatively, the first cold plate 302 can have a wick/capillary design (e.g., a grooved wick design, a sintered wick design, mesh-weave wick design, etc.). In some examples, the coolant flowing through the first cold plate 302 can flow via natural convection and/or forced convection (e.g., via a pump, etc.).

Although in the example of FIG. 3A and more generally, in examples disclosed here, the cold plate (e.g., the cold plate 302) is carried by a stiffener plate (e.g., the stiffener 108), in other examples, the cold plate can be carried by other types of structures and/or structures having different material properties, etc. coupled to the printed circuit board. In other examples, the cold plate may be coupled to the printed circuit board independent of a support structure for the cold plate.

FIG. 3B is a front view of an example second stiffener subassembly 310 that can be used in connection with the printed circuit board assembly 100 of FIGS. 1A-2. In some examples, the second stiffener subassembly 310 can be used to implement the second stiffener 108 of FIGS. 1B and 2. In the illustrated example of FIG. 3B, an example cold plate 312 is disposed in the example region 114 (FIG. 1B) of the second stiffener 108. In the illustrated example of FIG. 3B, the cold plate 312 includes an example cold plate inlet 314 and an example cold plate outlet 316, which extend through an example first hole 318A and an example second hole 318B in the second stiffener, respectively. The cold plate 312 of FIG. 3B is similar to the first cold plate 302 of FIG. 3A except that the cold plate inlet 314 and cold plate outlet 316 are disposed on opposite sides of the cold plate 312. In the illustrated example of FIG. 3B, the cold plate inlet 314 and the cold plate outlet 316 are displaced as represented by line 320 in FIG. 3B. In other examples, the cold plate inlet 314 and the cold plate outlet 316 can be colinear.

While two example inlet and outlet configurations of the cold plates 302, 312 of the stiffener subassemblies 300, 310 are described in conjunction with FIGS. 3A and 3B, it should be appreciated that other inlet and outlet configurations of cold plates of stiffener subassemblies can be used. For example, the inlet and the outlet of a cold plate implemented in accordance with the teachings of this disclosure can be disposed on adjacent sides of the cold plate (e.g., a left side of the cold plate and a top side of the cold plate, etc.).

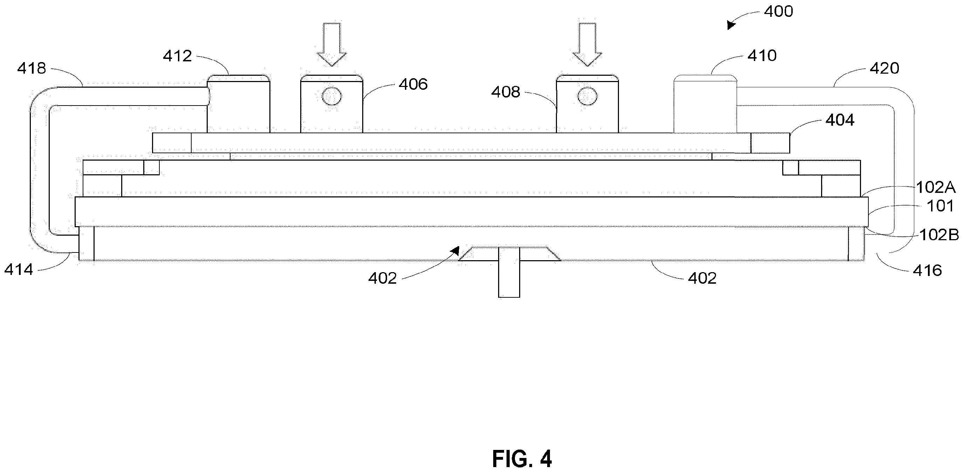

FIG. 4 is a side view of an example integrated dual-sided cold plate assembly 400 including the example printed circuit board assembly 100 of FIGS. 1A-2, an example stiffener subassembly 402, and an example primary side cold plate 404. In the illustrated example of FIG. 4, the example primary side cold plate 404 includes a first primary side inlet 406, a first primary side outlet 408, a second primary side inlet 410, and a second primary side outlet 412. In the illustrated example of FIG. 4, the stiffener subassembly 402 includes a secondary side inlet 414 and a secondary side outlet 416. In the illustrated example of FIG. 4, the second primary side outlet 412 is coupled to the secondary side inlet 414 via a first coolant conduit 418 and the second primary side inlet 410 is coupled to the secondary side outlet 416 via a second coolant conduit 420.

The example stiffener subassembly 402 of FIG. 4 is a back plate stiffener subassembly, which includes an example cold plate disposed within the region 114. In some examples, the stiffener subassembly 402 can be implemented by the first stiffener subassembly 300 of FIG. 3A and/or the second stiffener subassembly 310. In some such examples, the example secondary side inlet 414 can be coupled to the cold plate inlet 304 of the first stiffener subassembly 300 of FIG. 3A and/or the cold plate inlet 314 of the second stiffener subassembly 310 of FIG. 3B via one or more tubes and/or pipes (not illustrated). In some such examples, the example secondary side outlet 416 can be coupled to the cold plate outlet 306 of the first stiffener subassembly 300 of FIG. 3A and/or the cold plate outlet 316 of the second stiffener subassembly 310 of FIG. 3B via one or more tubes and/or pipes (not illustrated).

The primary side cold plate 404 is a thermo-mechanical structure that dissipates heat generated by electronic component(s) coupled to the primary side 102A of the printed circuit board 101 (e.g., the integrated circuit formed on the die 106 of FIG. 1A, etc.). In some examples, the primary side cold plate 404 is larger than the cold plate of the stiffener subassembly 402 (e.g., the first cold plate 302 of FIG. 3A, the cold plate 312 of FIG. 3B, etc.) because the primary side 102A of the printed circuit board 101 is no subject to the same packaging constraints as the second side 102B of the printed circuit board 101. In some examples, the primary side cold plate 404 can be composed of any suitable thermally conductive material (e.g., copper, aluminum, brass, silver, etc.). In some examples, the primary side cold plate 404 includes one or more internal coolant pathways, through which liquid coolant flows. In some examples, the primary side cold plate 404 can be manufactured via additive manufacturing. Additionally or alternatively, the primary side cold plate 404 can be manufactured in any other suitable manner (e.g., casting, machining, etc.). In some examples, a thermally conductive paste can be disposed between the die 106 of FIG. 1A and the primary side cold plate 404 to increase the rate of conduction therebetween. In some examples, the primary side cold plate 404 can be coupled to the printed circuit board assembly 100 via one or more fasteners extending through corresponding ones of the apertures 112A, 112B, 112B, 112C of FIGS. 1A and 1B.

The coolant conduits 418, 420 are structures that connect the primary side cold plate 404 and the cold plate (e.g., the cold plate 302, 312) of the stiffener subassembly 402 and facilitate the flow of coolant therebetween. In some examples, one or both of the coolant conduits 418, 420 can be flexible non-conductive tubes (e.g., rubber tubes, plastic tubes, etc.). Additionally or alternatively, one or both of the coolant conduits 418, 420 can be rigid or substantially rigid tubes (e.g., metal piping, plastic tubes, etc.). In the illustrated example of FIG. 4, the arrangement of the second primary side inlet 410, the second primary side outlet 412, the secondary side inlet 414 and the secondary side outlet 416 causes the coolant conduits 418, 420 to be disposed on opposite sides of the integrated dual-sided cold plate assembly 400. In other examples, depending on the arrangement of the second primary side inlet 410, the second primary side outlet 412, the secondary side inlet 414 and the secondary side outlet 416, the coolant conduits 418, 420 can have other configurations (e.g., the coolant conduits 418, 420 can be disposed on a same side of the integrated dual-sided cold plate assembly 400, etc.).

In the illustrated example of FIG. 4, the primary side cold plate 404 and the cold plate (e.g., the cold plate 302, 312) of the stiffener subassembly 402 are arranged such that coolant flows through the cold plates in sequence. For example, during operation, coolant enters the primary side cold plate 404 through the first primary side inlet 406, flows through a first internal flow path (not illustrated) of the primary side cold plate 404, and leaves through the second primary side outlet 412. After leaving the primary side cold plate 404, the coolant enters the stiffener subassembly 402 through the example secondary side inlet 414, enters the cold plate of the stiffener subassembly 402 (e.g., the first cold plate 302 of FIG. 3A and/or the cold plate 312 of FIG. 3A, etc.), and leaves the cold plate of the stiffener subassembly 402 via the secondary side outlet 416. After leaving the stiffener subassembly 402, the coolant flows through the second coolant conduit 420, reenters the primary side cold plate 404 via the second primary side inlet 410, flows through a second internal flow path (not illustrated) of the primary side cold plate 404, and leaves the primary side cold plate 404 via the first primary side outlet 408. Thus, the coolant flowing through the integrated dual-sided cold plate assembly 400 of FIG. 4 flows, in sequence, through the primary side cold plate 404, the stiffener subassembly 402, and the primary side cold plate 404.

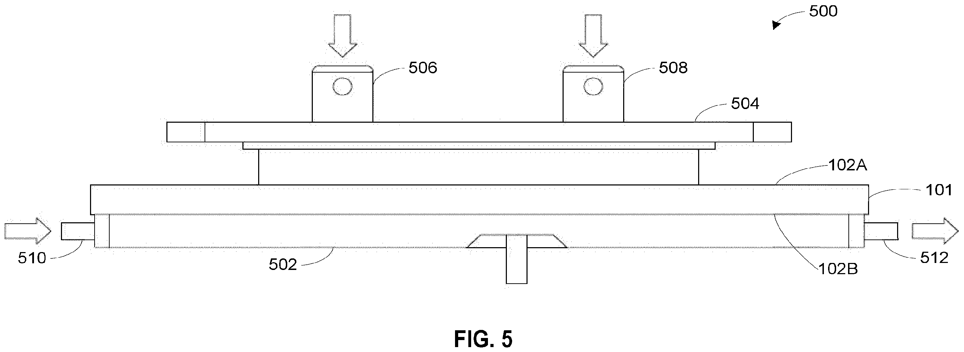

FIG. 5 is a side view of an example independent dual-sided cold plate assembly 500 including an example stiffener subassembly 502, an example primary side cold plate 504, and the example printed circuit board assembly 100 of FIGS. 1A-2. In some examples, the stiffener subassembly 502 can be implemented by the first stiffener subassembly 300 of FIG. 3A and/or the second stiffener subassembly 310 of FIG. 3B. In the illustrated example of FIG. 5, the example primary side cold plate 504 includes a primary side inlet 506 and a first primary side outlet 508. In the illustrated example of FIG. 5, the stiffener subassembly 502 includes a secondary side inlet 510 and a secondary side outlet 512. The stiffener subassembly 502 and the primary side cold plate 504 of FIG. 5 are substantially similar to the stiffener subassembly 402 of FIG. 4 and the primary side cold plate 404 of FIG. 4, respectively, except that the independent dual-sided cold plate assembly 500 does not include the coolant conduits therebetween (e.g., the coolant conduits 418, 420 of FIG. 4, etc.).

In the illustrated example of FIG. 5, the primary side cold plate 504 and the cold plate (e.g., the cold plate 302, 312 of FIGS. 3A and/or 3B) of the stiffener subassembly 502 are arranged such that coolant flows through the cold plates in parallel. For example, during operation, coolant enters the primary side cold plate 504 through the primary side inlet 506, flows through a first internal flow path (not illustrated) of the primary side cold plate 504, and leaves through the primary side outlet 508. Separately and, in some instances, simultaneously, coolant enters the stiffener subassembly 502 through the secondary side inlet 510, enters the cold plate of the stiffener subassembly 502 (e.g., the first cold plate 302 of FIG. 3A and/or the cold plate 312 of FIG. 3A, etc.), and leaves the cold plate of the stiffener subassembly 502 via the secondary side outlet 512. That is, the coolant flowing through the independent dual-sided cold plate assembly 500 of FIG. 5 flows in separate coolant pathways of the primary side cold plate 504 and the stiffener subassembly 502 that are not fluidly coupled as in the example of FIG. 4.

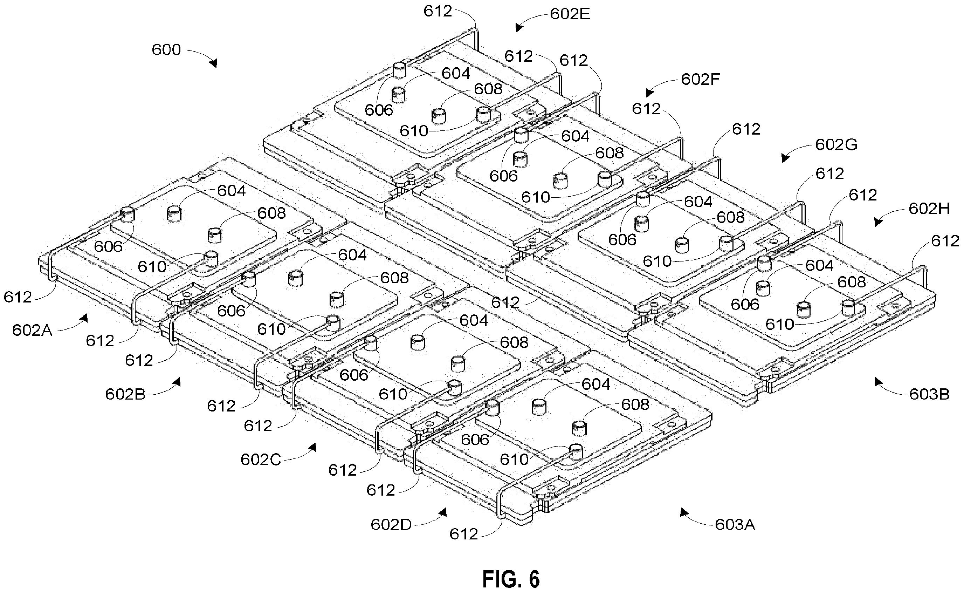

FIG. 6 is a perspective view of an example array 600 including a plurality of dual-sided cold plate assemblies that are the same or substantially similar to the integrated dual-sided cold plate assembly 400 of FIG. 4. In the illustrated example of FIG. 6, the array 600 includes an example first dual-sided cold plate assembly 602A, an example second dual-sided cold plate assembly 602B, an example third first dual-sided cold plate assembly 602C, an example fourth dual-sided cold plate assembly 602D, an example fifth dual-sided cold plate assembly 602E, an example sixth dual-sided cold plate assembly 602F, an example seventh dual-sided cold plate assembly 602G, and an example eighth dual-sided cold plate assembly 602H. In the illustrated example of FIG. 6, each of the dual-sided cold plate assemblies 602A, 602B, 602C, 602D, 602E, 602F, 602G, 602H is similar to the integrated dual-sided cold plate assembly 400 of FIG. 4. In some examples, the array 600 can be coupled to a baseboard, such as the baseboard 200 of FIG. 2.

In the illustrated example of FIG. 6, the dual-sided cold plate assemblies 602A, 602B, 602C, 602D, 602E, 602F, 602G, 602H are arranged into two linear columns. That is, in the illustrated example of FIG. 6, the first dual-sided cold plate assembly 602A, the second dual-sided cold plate assembly 602B, the third dual-sided cold plate assembly 602C, are the fourth dual-sided cold plate assembly 602D are arranged in a first column 603A and the fifth dual-sided cold plate assembly 602E, the sixth dual-sided cold plate assembly 602F, the seventh dual-sided cold plate assembly 602G, and the eighth dual-sided cold plate assembly 602H are arranged in a second column 603B parallel to the first column 603A. In other examples, the array 600 can have any other suitable arrangement of dual cold plate assemblies and/or can include a different number of assemblies (e.g., more cold plate assemblies, etc.).

In the illustrated example of FIG. 6, each of the dual-sided cold plate assemblies 602A, 602B, 602C, 602D, 602E, 602F, 602G, 602H includes a corresponding one of an example first plurality of inlets 604, a corresponding one of an example second plurality of inlets 606, a corresponding one of an example first plurality of outlets 608, and a corresponding one of an example second plurality of outlets 610. In the illustrated example of FIG. 6, example coolant conduits 612 are disposed between the second plurality of inlets 606 and the second plurality of outlets 610 such that the primary side cold plates (e.g., similar to the primary side cold plate 404 of FIG. 4, etc.) and the secondary side cold plates (e.g., similar to the stiffener subassembly 402 of FIG. 4, etc.) receive coolant in sequence (e.g., flow sequentially from the primary side cold plate of each of the dual-sided cold plate assemblies 602A, 602B, 602C, 602D, 602E, 602F, 602G, 602H to the secondary side cold plate of each of the dual-sided cold plate assemblies 602A, 602B, 602C, 602D, 602E, 602F, 602G, 602H, etc.).

In some examples, conduits (not illustrated) are disposed between corresponding ones of the first plurality of inlets 604 such that coolant flows between the dual-sided cold plate assemblies 602A, 602B, 602C, 602D, 602E, 602F, 602G, 602H in sequence. For example, coolant can be received (e.g., from a coolant distribution unit, from a chiller, from a heat exchanger, etc.) by one of the first plurality of inlets 604 of the first dual-sided cold plate assemblies 602A, flow through the primary side cold plate and the second side cold plate of the first dual-sided cold plate assemblies 602A, and leave through a corresponding one of the first plurality of outlets 608. After leaving the first dual-sided cold plate assemblies 602A via one of the first plurality of outlets 608, the coolant can enter the second dual-sided cold plate assembly 602B via a corresponding one of the first plurality of inlets 604 and proceed accordingly through the dual-sided cold plate assemblies 602C, 602D, 602E, 602F, 602G, 602H of the array 600. In other examples, coolant conduits (not illustrated) can individually and independently connect ones of the first plurality of inlets 604 and ones of the first plurality of outlets 608 to a coolant source such coolant flows through each of the dual-sided cold plate assemblies 602A, 602B, 602C, 602D, 602E, 602F, 602G, 602H in parallel.

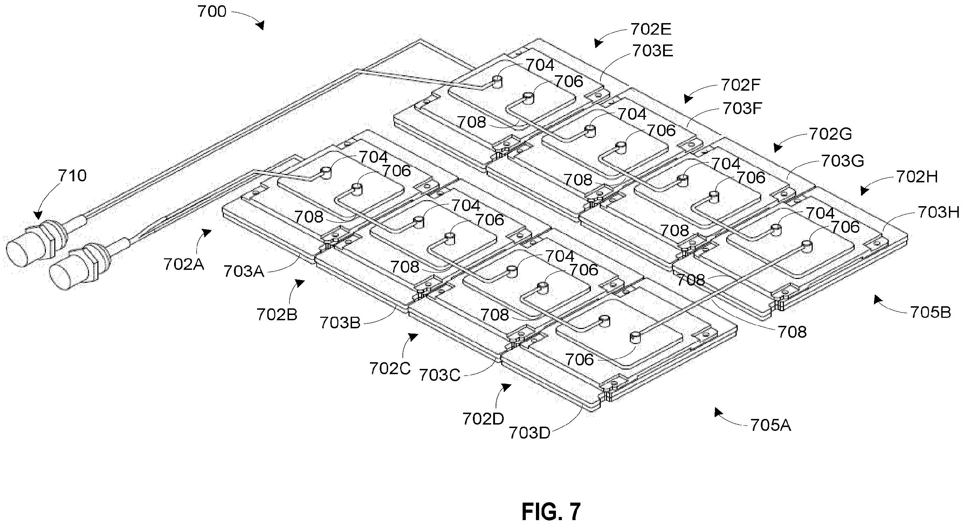

FIG. 7 is a perspective view of another example array 700 including a plurality of secondary side assemblies, similar to the cold plate assemblies of 502 of FIG. 5. In the illustrated example of FIG. 7, the array 700 includes an example first secondary side cold plate assembly 702A, an example second secondary side cold plate assembly 702B, an example third secondary side cold plate assembly 702C, an example fourth secondary side cold plate assembly 702D, an example fifth secondary side cold plate assembly 702E, an example sixth secondary side cold plate assembly 702F, an example seventh secondary side cold plate assembly 702G, and an example eighth secondary side cold plate assembly 702H. In the illustrated example of FIG. 7, each of the secondary side cold plate assemblies 702A, 702B, 702C, 702D, 702E, 702F, 702G, 702H is similar to the stiffener subassembly 502 of FIG. 5. Each of the secondary side cold plate assemblies 702A, 702B, 702C, 702D, 702E, 702F, 702G, 702H is coupled to an example first printed circuit board 703A, an example second printed circuit board 703B, an example third printed circuit board 703C, an example fourth printed circuit board 703D, an example fifth printed circuit board 703E, an example sixth printed circuit board 703F, an example seventh printed circuit board 703G, and an example eighth printed circuit board 703H, respectively. In some examples, some or all of the printed circuit boards 703A, 703B, 703C, 703D, 703E, 703F, 703G, 703H of the array 700 can be coupled to a baseboard, such as the baseboard 200 of FIG. 2. In the illustrated example of FIG. 7, each of the printed circuit boards 703A, 703B, 703C, 703D, 703E, 703F, 703G, 703H is similar to the printed circuit board 101 of FIGS. 1A, 1B, 2 and 5.

In the illustrated example of FIG. 7, the secondary side cold plate assemblies 702A, 702B, 702C, 702D, 702E, 702F, 702G, 702H are arranged into two linear columns. That is, in the illustrated example of FIG. 7, the first secondary side cold plate assembly 702A, the second secondary side cold plate assembly 702B, the third secondary side cold plate assembly 702C, are the fourth secondary side cold plate assembly 702D are arranged in an example first column 705A and the fifth secondary side cold plate assembly 702E, the sixth secondary side cold plate assembly 702F, the seventh secondary side cold plate assembly 702G, and the eighth dual-sided cold plate assembly 702H are arranged in an example second column 705B parallel to the first column 705A. In other examples, the array 700 can have any other suitable arrangement of secondary side plate assemblies and/or can include a different number of assemblies (e.g., more cold plate assemblies, etc.).

In the illustrated example of FIG. 7, each of the secondary side cold plate assemblies 702A, 702B, 702C, 702D, 702E, 702F, 702G, 702H includes a corresponding one of an example plurality of inlets 704 and a corresponding one of an example plurality of outlets 706. In the illustrated example of FIG. 7, the example coolant conduits 708 are disposed between corresponding ones of the plurality of inlets 704 such that coolant flows between the secondary side cold plate assemblies 702A, 702B, 702C, 702D, 702E, 702F, 702G, 702H in sequence. That is, the first secondary side cold plate assembly 702A receives coolant from an example coolant source 710 via a corresponding one of the plurality of inlets 704, which flows through an internal coolant flow path of the first secondary side cold plate assembly 702A, and exits via a corresponding one of the plurality of inlets 704. In the illustrated examples, after leaving the first secondary side cold plate assembly 702A, coolant flows through a corresponding portion of the coolant conduits 708 into the corresponding one of the inlets 704 of the second secondary side cold plate assembly 702B. After leaving the second secondary side cold plate assemblies 702B via one of the plurality of outlets 706, the coolant can enter the third dual-sided cold plate assembly 602C via a corresponding one of the plurality of inlets 704, proceed accordingly through the secondary side cold plate assemblies 702D, 702E, 702F, 702G, 702H of the array 700 via the coolant conduits 708 and back to the coolant source 710. In other examples, the coolant conduits 708 can individually and independently connect ones of the plurality of inlets 704 and ones of the plurality of outlets 706 to the coolant source 710 such coolant flows through each of the secondary side cold plate assemblies 702A, 702B, 702C, 702D, 702E, 702F, 702G, 702H in parallel.

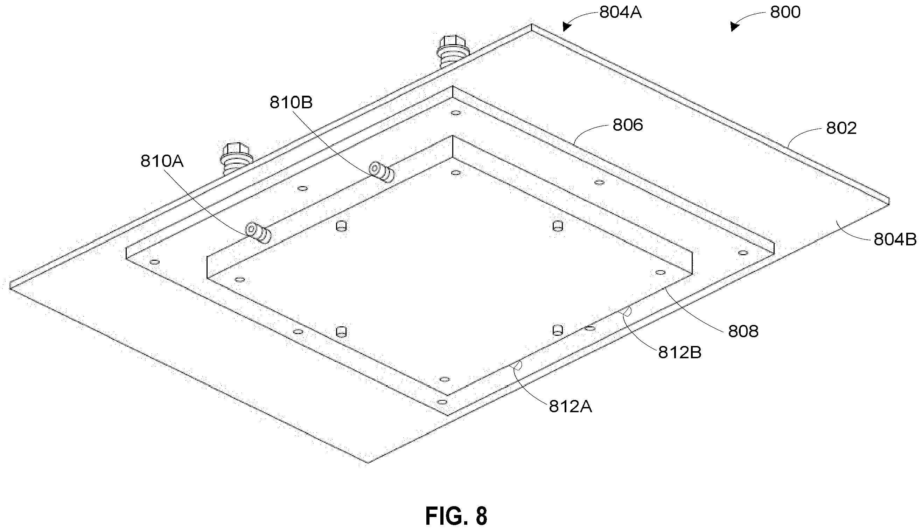

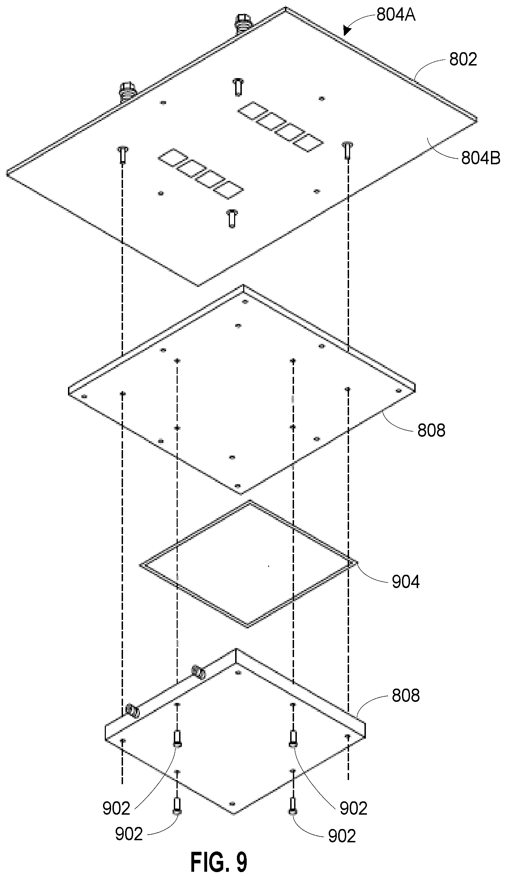

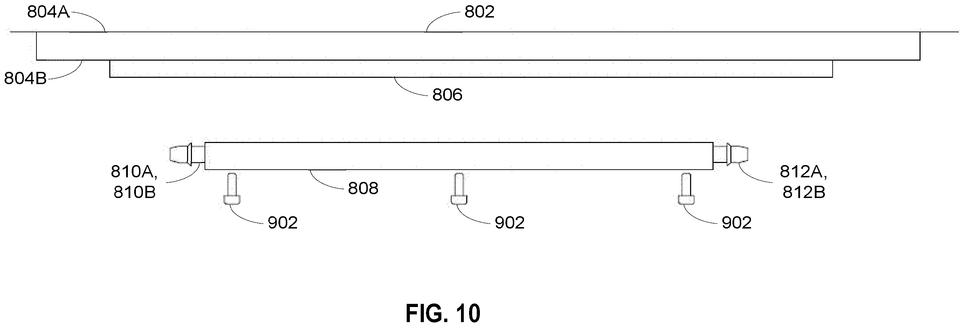

FIG. 8 is a bottom perspective view of another example secondary side cold plate assembly 800 coupled to a printed circuit board 802. FIG. 9 is a bottom perspective exploded view of the secondary side cold plate assembly 800 of FIG. 8. FIG. 10 is a side exploded view of the secondary side cold plate assembly 800 of FIGS. 8 and 9. In the illustrated example of FIGS. 8-10, the printed circuit board 802 includes an example primary side 804A and an example secondary side 804B. In the illustrated example of FIGS. 8-10, the secondary side cold plate assembly 800 includes an example stiffener 806 and an example cold plate 808. As shown in FIGS. 9 and 10, the secondary side cold plate assembly 800 further includes example fasteners 902 and an example seal 904.

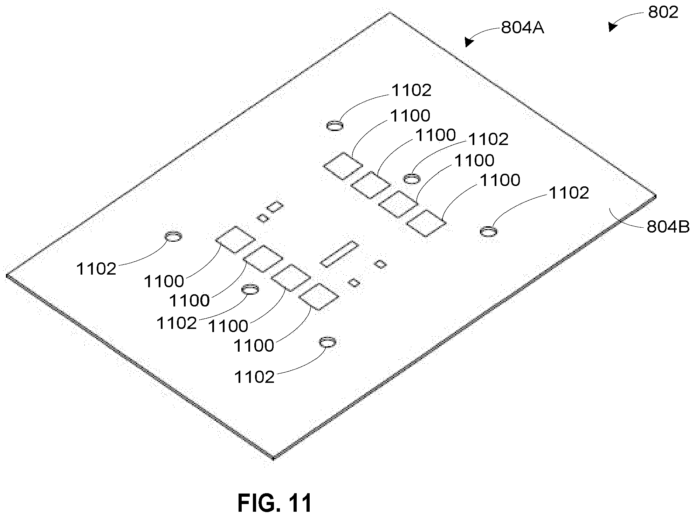

The printed circuit board 802 is similar to the printed circuit board 101 of FIGS. 1A and 1B, except that the printed circuit board 802 includes heat-generating components disposed on the secondary side 804B (e.g., in addition to heat-generating components disposed on the primary side 804A). The printed circuit board 802 of FIGS. 8-10 can have any suitable form factor including core protocol (OCP) accelerator module (OAM) form factor. In other examples, the printed circuit board 802 can have any other form factor (e.g., a peripheral component interconnect express (PCIe) card electromechanical (CEM) form factor, a PCIe M.2 form factor, a PCIe U.2 form factor, etc.). The printed circuit board 802 can support the integrated circuit of an accelerator (e.g., a graphics processor unit (GPU), etc.) and/or another compute component. In some examples, the printed circuit board 802 can be coupled to another PCB (e.g., a baseboard, a motherboard, etc.). In some such examples, the secondary side 804B of the printed circuit board 802 is adjacent to the other PCB, and the primary side 804A is distal to the other PCB. The printed circuit board 802 is described in greater detail below in connection with FIG. 11.

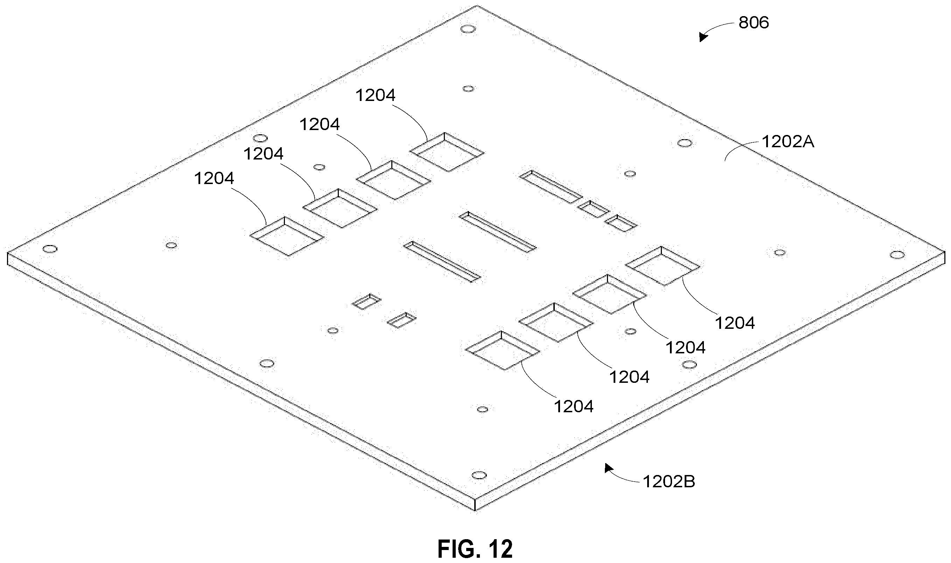

The stiffener 806 is a mechanical component that increases the stiffness (e.g., rigidity, etc.) of the secondary side cold plate assembly 800. In the illustrated example of FIGS. 8-10, the stiffener 806 is coupled to and abuts the secondary side 804B of the printed circuit board 802. The stiffener 806 mitigates the deformation of the printed circuit board 802 (e.g., caused by the coupling of the printed circuit board 802 to another PCB, caused by the coupling a heat sink and/or cold plate the primary side 804A of the printed circuit board 802, etc.). The stiffener 806 can be composed of any suitable material with a suitably high elastic modulus (e.g., steel, reinforced plastic, aluminum, etc.). In some examples, the stiffener 806 includes apertures (e.g., holes, cutouts, etc.) to receive the heat-generating components of the secondary side 804B. The stiffener 806 is disclosed below in greater detail below in connection with FIG. 12.

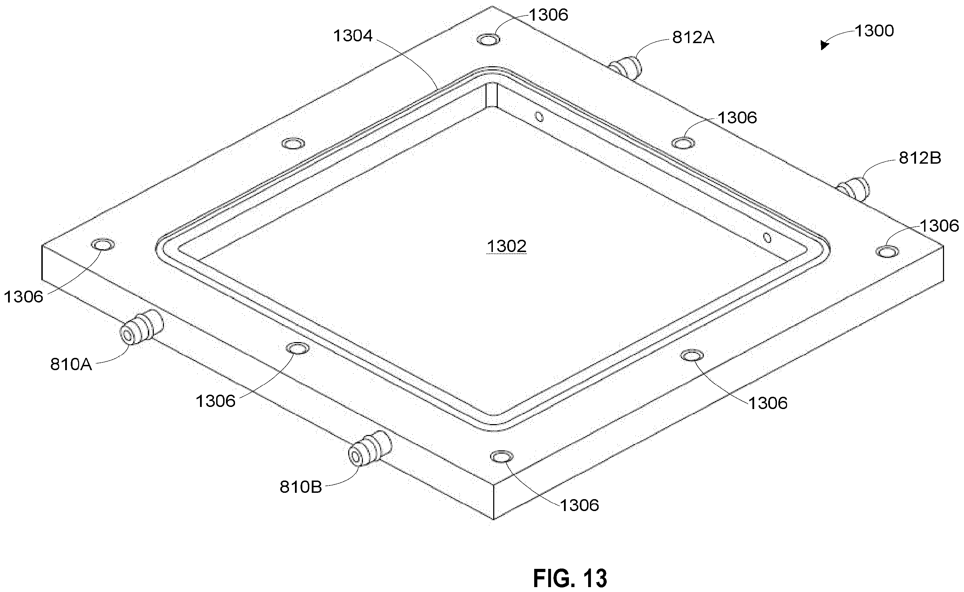

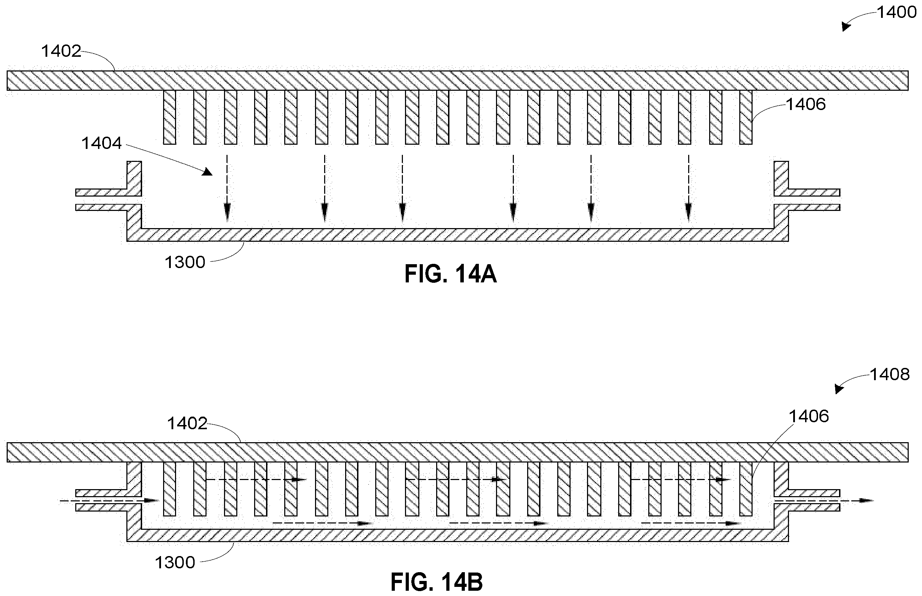

The cold plate 808 is a thermo-mechanical structure that dissipates heat generated by the heat-generating electronic components of the printed circuit board 802. In particular, in the example of FIGS. 8-10, the cold plate 808 facilitate cooling of heat-producing components disposed on the secondary side 804B. In some examples, the cold plate 808 is a two-part assembly that includes a cold plate housing and a plate (e.g., a top plate). An example cold plate housing of the cold plate 808 is disclosed below in connection with FIG. 13. The coupling of the two-part assembly to form the cold plate 808 is disclosed below in connection with FIG. 14.

Referring to FIGS. 9 and 10, the cold plate 808 includes the seal 904 to prevent coolant from leaking from the cold plate 808. In some examples, the seal 904 can be implemented by an O-ring and/or a rubber gasket. In other examples, the seal 904 can be implemented by any other suitable type of seal. In other examples, the cold plate 808 can be formed as a single integral component. In some examples, the cold plate 808 can be composed of any suitable thermally conductive material (e.g., copper, aluminum, brass, silver, etc.). In some examples, the cold plate 808 can be manufactured via additive manufacturing. Additionally or alternatively, the cold plate 808 can be manufactured in any other suitable manner (e.g., casting, machining, etc.).

During the operation of the secondary side cold plate assembly 800, the cold plate 808 absorbs heat from the printed circuit board 802 (e.g., via conduction through the stiffener 806, etc.). In the illustrated example of FIGS. 8-10, the cold plate 808 includes a first inlet 810A, a second inlet 810B, a first outlet 812A, and a second outlet 812B. In some examples, a coolant flows into the cold plate 808 via the inlets 810A, 810B, absorbs heat from the body of the cold plate 808, and leaves the cold plate 808 via the outlets 812A, 812B. While the cold plate 808 of FIGS. 8-10 include two inlets (e.g., the inlets 810A, 810B, etc.) and two outlets (e.g., the outlets 812A, 812B, etc.), in other examples, the cold plate 808 can include any other suitable numbers of inlets and outlets (e.g., 1 inlet and 1 outlet, 3 inlets and 3 outlets, 1 inlet and 2 outlets, etc.)

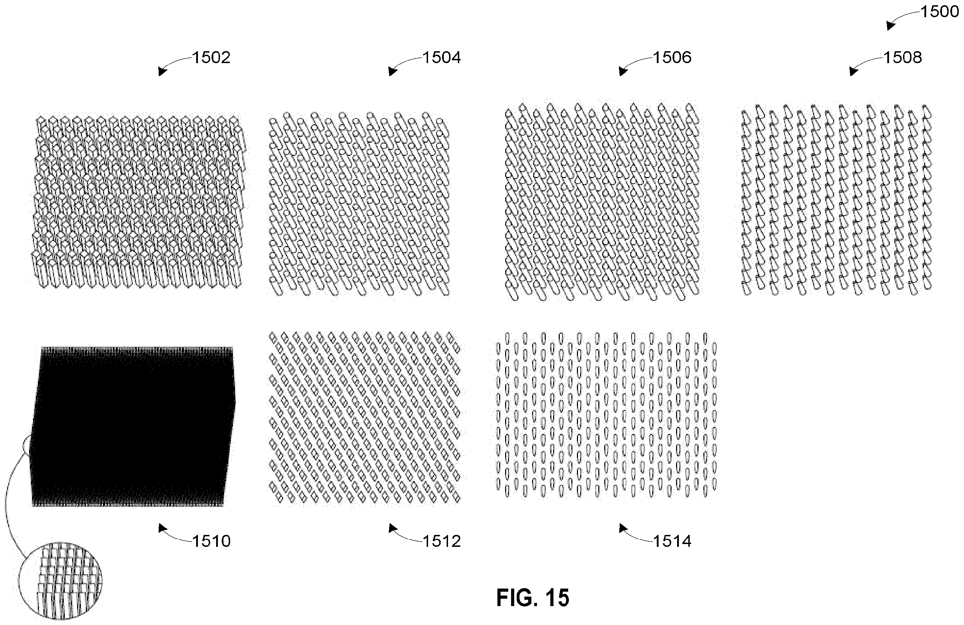

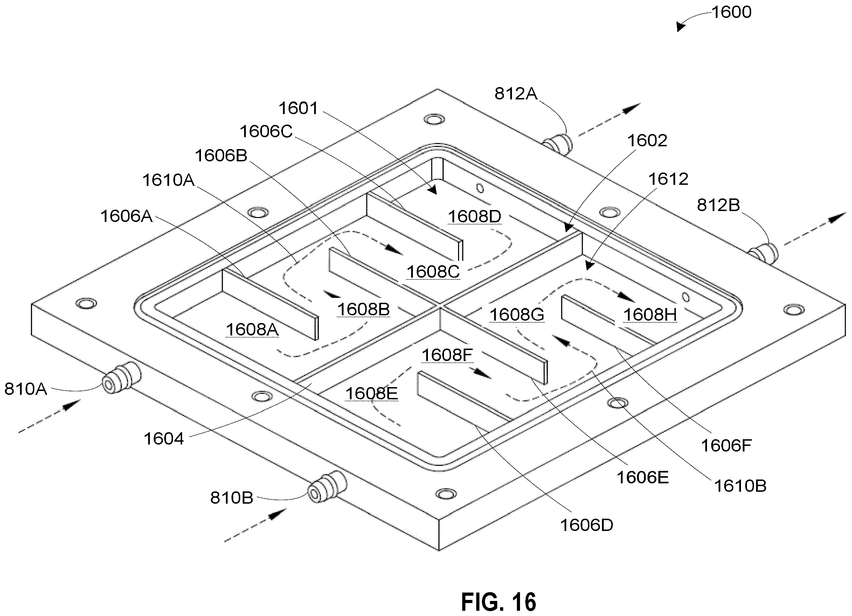

The coolant of the cold plate 808 can include ammonia, methanol, ethanol, water, mercury, hydrofluorocarbon refrigerants hydrocarbons (e.g., mineral oil, hexane, castor oil, etc.), acetone, esters, and/or an electrically insulative coolant (e.g., fluorinated ketones, per-fluorinated compounds, etc.), benzene, etc. In some examples, the cold plate 808 can include one or more internal fin structures that increase the internal surface area of the cold plate 808 exposed to the flow of coolant there through. Example fin structures that can be used in conjunction with the cold plate 808 are disclosed below in connection with FIG. 15. Additionally or alternatively, the cold plate 808 can include an internal wall structure that increases the internal surface area of the cold plate 808 exposed to the flow of coolant therethrough. An example internal wall structure that can be used with the cold plate 808 is disclosed below in connection with FIG. 16. In some examples, the coolant flowing through the cold plate 808 can vaporize. In other examples, the coolant flowing through the cold plate 808 can remain in a liquid phase. In some examples, the coolant flowing the cold plate 808 can flow via natural convection and/or forced convection (e.g., via a pump, etc.).

In the illustrated example of FIGS. 8-10, the cold plate 808 is coupled to the stiffener 806 via the fasteners 902. The fasteners 902 can be implemented by any suitable type of fastener (e.g., screws, bolts, etc.). Additionally or alternatively, the cold plate 808 can be coupled to the stiffener 806 via one more welds, one or more chemical adhesives, one or more press fits, one or more shrink fits, etc. In some examples, the cold plate 808 can be integral with the stiffener 806.

FIG. 11 is a perspective view of the printed circuit board 802 of FIGS. 8-10. In the illustrated example of FIG. 11, the printed circuit board 802 includes example heat-producing components 1100. The printed circuit board 802 includes holes 1102 defined therein. The heat-producing components 1100 are disposed on the secondary side 804B of the printed circuit board 802. The heat-producing components 1100 generate heat during the operation. In the illustrated example of FIG. 11, the heat-producing components 1100 may be at least partially spaced apart from the secondary side 804B and/or extend therefrom. In some examples, some or all of the heat-producing components 1100 are voltage regulators (VRs). Additionally or alternatively, some or all of the heat-producing components 1100 are field-effect transistors (FETs). Additionally or alternatively, the heat-producing components 1100 can be any other heat-producing components (e.g., integrated circuit components, processor circuitry, etc.). In the illustrated example of FIG. 11, the secondary side 804B of the printed circuit board 802 includes eight heat-producing components (e.g., the heat-producing components 1100, etc.), which are arranged in two equally-sized rows. In other examples, the printed circuit board 802 can include any suitable number of heat-producing components. In other examples, the heat-producing components 1100 can have any suitable configuration.

In the illustrated example of FIG. 11 the holes 1102 extend through the printed circuit board 802. In some examples, one or more fasteners (not illustrated) can extend through corresponding ones of the holes 1102 to couple a heat sink and/or a cold plate to the primary side 804A of the printed circuit board 802. In other examples, one or more of the holes 1102 can be absent. In some such examples, the printed circuit board 802 can include other features to enable the coupling of a heat sink and/or a cold plate thereto.

FIG. 12 is a perspective view of the stiffener 806 of the secondary side cold plate assembly 800 of FIGS. 8-10. In the illustrated example of FIG. 12, the stiffener 806 has an example first side 1202A and an example second side 1202B and includes example cavities 1204 (e.g., grooves). Put another way, in the illustrated example of FIG. 12, the cavities 1204 are blind holes (e.g., the cavities 1204 do not extend through the stiffener 806, etc.). When the stiffener 806 is coupled with the secondary side cold plate assembly 800 of FIGS. 8-10, the first side 1202A abuts the secondary side 804B of the printed circuit board 802 and the second side 1202B abuts the cold plate 808.

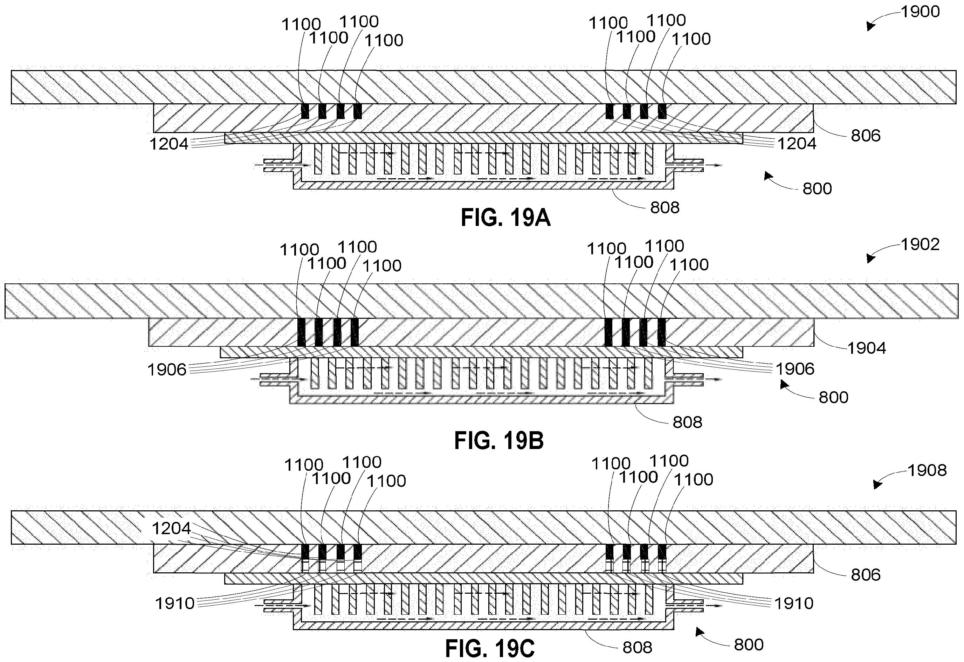

The cavities 1204 of the stiffener 806 at least partially receive the heat-producing components 1100 of FIG. 11 of the printed circuit board 802. The cavities 1204 can have a complementary size and shape to the heat-producing components 1100. In other examples, the cavities 1204 can be larger than the heat-producing components. In some examples, the cavities 1204 can be formed in the stiffener 806 via negative manufacturing (e.g., machining, etc.). In other examples, the cavities 1204 can be formed in the stiffener 806 during the initial manufacturing of the stiffener 806. An example configuration of the secondary side cold plate assembly 800 is disclosed below in additional detail in connection with FIG. 19A. In other examples, the stiffener 806 includes one or more through holes instead of the blind holes or cavities 1204. Example configurations of the secondary side cold plate assembly 800 including through holes are described below in additional detail in conjunction with FIG. 19C.

FIG. 13 is a perspective view of an example cold plate housing 1300 of the cold plate 808 of FIGS. 8-10. In the illustrated example of FIG. 13, the cold plate housing 1300 includes an internal cavity 1302, a trench 1304, and apertures 1306. In the illustrated example of FIG. 13, the cold plate housing 1300 includes the inlets 810A, 810B of FIGS. 8-10 and the outlets 812A, 812B of FIGS. 8-10. The internal cavity 1302 of the cold plate housing 1300 defines an opening formed within the cold plate 808 to receive coolant. The internal cavity 1302, the inlets 810A, 810B, and the outlets 812A, 812B define an interior flow path through which the coolant of the cold plate 808 flows. In some examples, the cold plate housing 1300 can include one or more walls and/or one or more fins extending upward from a bottom interior surface of the cavity 1302. In some such examples, the one or more walls and/or one or more fins increase the relative area of the cold plate 808 exposed to the coolant flow, thereby increasing the rate of convection therebetween. Example fin configurations that can be used with the cold plate housing 1300 are disclosed below in connection with FIG. 15. An example cold plate housing including internal walls is disclosed below in connection with FIG. 16.

In the illustrated example of FIG. 13, the trench 1304 of the cold plate housing 1300 surrounds the internal cavity 1302. In the illustrated example of FIG, 13, the trench 1304 is a groove formed in a (e.g., top) surface of the cold plate housing 1300. In some examples, the trench 1304 can receive and retain the seal 904 of FIGS. 9 and 10. In the illustrated example of FIG. 13, the trench 1304 extends fully around the internal cavity 1302. In the illustrated example of FIG. 13, the trench 1304 has a constant depth and width. In other examples, the trench 1304 can have a variable depth, length, and/or width. In some examples, if the cold plate 808 is integral with a plate (e.g., a top plate), the trench 1304 can be absent (e.g., because a seal may not be needed).

The apertures 1306 are through holes that permit the cold plate housing 1300 to be coupled to a plate (e.g., the plate 1402 of FIG. 14, etc.) and/or the other components of the secondary side cold plate assembly 800 of FIGS. 8-10 and/or the printed circuit board 802. In some examples, some or all of the apertures 1306 can receive the fasteners 902 of FIGS. 9 and 10. The cold plate housing 1300 can include any suitable number of apertures 1306 (e.g., 8 apertures as shown FIG. 13, fewer or more apertures), which can receive a corresponding number of fasteners.

FIG. 14A is a schematic diagram illustrating the cold plate housing 1300 of FIG. 13 and an example plate 1402 in a disassembled state 1400. When the cold plate housing 1300 is in the orientation of FIG. 14A, the plate 1402 can be considered a top plate. In the illustrated example, the top plate 1402 is disposed on the cold plate housing 1300 as represented by arrows 1404 of FIG. 14A. When used with the printed circuit board 802, the top plate 1402 can at least partially abut the stiffener 806 coupled to the secondary side 804B of the printed circuit board 802. In the illustrated example of FIG. 14A, the cold plate 808 is a two-part assembly including the top plate 1402 and the cold plate housing 1300. As disclosed herein, the cold plate housing 1300 can include or support additional components such as the seal 904 of FIGS. 9-10. In other examples, the cold plate housing 1300 and the top plate 1402 (or portions thereof) are integrally formed (e.g., manufactured via additive manufacturing, etc.). In other examples, the cold plate 808 does not include the plate 1402 and the cold plate housing 1300 can directly abut the stiffener 806.

In the illustrated example of FIG. 14A, the top plate 1402 includes fins 1406 that extend from the top plate 1402 into the internal cavity 1302 of the cold plate housing 1300. In other examples, the fins 1406 can extend from the cold plate housing 1300 (e.g., from the internal cavity 1302) towards the top plate 1402. Example configurations for the fins 1406 are disclosed below in connection with FIG. 15. As disclosed above, in some examples, a seal (e.g., the seal 904 of FIGS. 9 and 10, etc.) can be disposed between the top plate 1402 and the cold plate housing 1300. In some examples, the top plate 1402 can include a lip (not illustrated) to facilitate the coupling of the top plate 1402 to the cold plate housing 1300 via an interference fit.

FIG. 14B is a schematic diagram illustrating the cold plate housing 1300 of FIG. 13 and an example top plate 1402 in an assembled state 1408. In the illustrated example of FIG. 14B, the example cold plate 808 of FIGS. 8-10 is formed by the coupling of the top plate 1402 and the cold plate housing 1300. In the illustrated example of FIG. 14B, the fins 1406 are disposed within the internal cavity 1302, which exposes the fins 1406 to the flow of coolant there through. In some such examples, the fins 1406 increases the surface area of the cold plate 808 exposed to the flow, which increases the rate of convection therebetween.

FIG. 15 is a perspective view of a plurality of fin configurations 1500 that can be used with the top fin plate of FIG. 14 and/or the cold plate housing of FIG. 13 of the example cold plate 808. In the illustrated example of FIG. 15, the fin configurations 1500 include an example first fin configuration 1502, an example second fin configuration 1504, an example third fin configuration 1506, an example fourth fin configuration 1508, an example fifth fin configuration 1510, an example sixth fin configuration 1512, an example seventh fin configuration 1514. As shown in FIG. 15, the fin configurations 1502, 1504, 1506, 1508, 1510, 1512, 1514 can vary with respect to shape (e.g., a cylindrical shape, a cone shape, a diamond shape, etc.). Also, spacing between the fins can vary (e.g., micro fins defining channels as in the fifth fin configuration 1510). Also, a size (e.g., thickness, height), shape, arrangement (e.g., layout, spacing, orientation), etc. of the fins can differ to affect the flow of coolant at the cold pate 808. Additional fin configurations and/or variations of the fin configurations 1500 of FIG. 15 can be used with the cold plate 808.

FIG. 16 is a perspective view of another example cold plate housing 1600 that can be used with the cold plate 808 of FIGS. 8-10. The example cold plate housing 1600 of FIG. 16 is similar to the cold plate housing 1300 of FIG. 13, except that an internal cavity 1601 of the cold plate housing 1600 includes an example internal wall structure 1602. In the illustrated example of FIG. 16, the internal wall structure 1602 includes a dividing wall 1604, a first wall segment 1606A, a second wall segment 1606B, a third wall segment 1606C, a fourth wall segment 1606D, and a fifth wall segment 1606E. The example wall segments 1606A, 1606B, 1606C, 1606D, 1606E, 1606F divide the internal cavity 1601 into a first section 1608A, a second section 1608B, a third section 1608C, a fourth section 1608D, a fifth section 1608E, a sixth section 1608F, a seventh section 1608G, and an eighth section 1608H. In the illustrated example of FIG. 16, the dividing wall 1604 defines a first coolant pathway 1610A and a second coolant pathway 1610B in the internal cavity 1601.

The internal wall structure 1602 increases the internal surface area of the cold plate housing 1600 exposed to the flow of the coolant therethrough, which increases the rate of convection between the cold plate housing 1600 and the coolant. In the illustrated example of FIG. 16, the coolant enters the cold plate housing 1600 via the first inlet 810A and flows via the first coolant pathway 1610A through the first section 1608A, through the second section 1608B, through third section 1608C, the fourth section 1608D and exits the cold plate housing 1600 via the first outlet 812A. In the illustrated example of FIG. 16, the coolant enters the cold plate housing 1600 via the second inlet 810B and flows via the second coolant pathway 1610B through the fifth section 1608E, through the sixth section 1608F, through the seventh section 1608G, through the eighth section 1608H and exits the cold plate housing 1600 via the second outlet 812B. In some examples, one or both of the coolant pathways 1610A, 1610B can include one or more fins structures. For example, some or all of the sections 1608A, 1608B, 1608C, 1608D, 1608E, 1608F, 1608G, 1608H can include fins (e.g., fins having one or more of the fin configurations 1500 of FIG. 15, etc.). In the illustrated example of FIG. 16, the coolant pathways 1610A, 1610B are fluidly isolated (e.g., coolant in the first coolant pathway 1610A does not mix with coolant in the second coolant pathway 1610B while within the internal cavity 1601). In other examples, the coolant pathways 1610A, 1610B are not fluidly isolated. In some such examples, the dividing wall 1604 can include one or more holes and/or openings to permit the flow coolant between the first coolant pathway 1610A and the second coolant pathway 1610B.

In the illustrated example of FIG. 16, the internal wall structure 1602 extends from a surface 1612 of the internal cavity 1601 (e.g., extends upward from the surface 1612 when the cold plate housing 1600 is oriented as shown in FIG. 16). In some such examples, at least a portion of the walls of the internal wall structure 1602 can abut a plate (e.g., the plate 1402 of FIGS. 14A and 14B, etc.) of the cold plate 808. In other examples, some or all of the walls of the internal wall structure 1602 do not abut the plate of the cold plate 808. In other examples, the internal wall structure 1602 can be formed in the plate (e.g., the top plate 1402 of FIGS. 14A and 14B, etc.) and extend towards the surface 1612 of the internal cavity 1601 when the plate is coupled to the cold plate housing 1600. In some such examples, at least a portion of the internal wall structure 1602 can abut the surface 1612. In some examples, the plate (e.g., the top plate 1402 of FIGS. 14A and 14B, etc.) can be absent. In some such examples, the cold plate housing 1600 can directly abut the stiffener 806, such that a surface of the stiffener 806 (e.g., the second side 1202B of FIG. 12, etc.) forms the upper boundary of the coolant pathways 1610A, 1610B.

In some examples, the internal wall structure 1602 (e.g., the dividing wall 1604 and the wall segments 1606A, 1606B, 1606C, 1606D, 1606E, 1606F, etc.) can be formed during the manufacturing of the cold plate housing 1600. For example, the internal wall structure 1602 can be formed via additive manufacturing and/or negative manufacturing (e.g., machining, etc.). In other examples, the internal wall structure 1602 can be manufactured separately and coupled within the internal cavity 1601 (e.g., via one or more welds, via one or more fasteners, via one or more interference fits, via one or more chemical adhesives, etc.). In some such examples, one or more of the dividing wall 1604 and/or the wall segments 1606A, 1606B, 1606C, 1606D, 1606E, 1606F can be manufactured using different material(s) than the other portions of the cold plate housing 1600.

In the illustrated example of FIG. 16, the cold plate housing 1600 includes six internal wall segments (e.g., the wall segments 1606A, 1606B, 1606C, 1606D, 1606E, 1606F, etc.) and a corresponding eight interior portions (e.g. the sections 1608A, 1608B, 1608C, 1608D, 1608E, 1608F, 1608G, 1608H, etc.). However, the cold plate housing 1600 can include any suitable number of internal wall segments and/or portions, which can divide the internal cavity 1601 into any suitable corresponding of coolant pathways. In the illustrated example of FIG. 16, each of the sections 1608A, 1608B, 1608C, 1608D, 1608E, 1608F, 1608G, 1608H have the same volume and have the same or substantially the same shape. In other examples, some or all of the sections 1608A, 1608B, 1608C, 1608D, 1608E, 1608F can have different volumes and/or shapes.

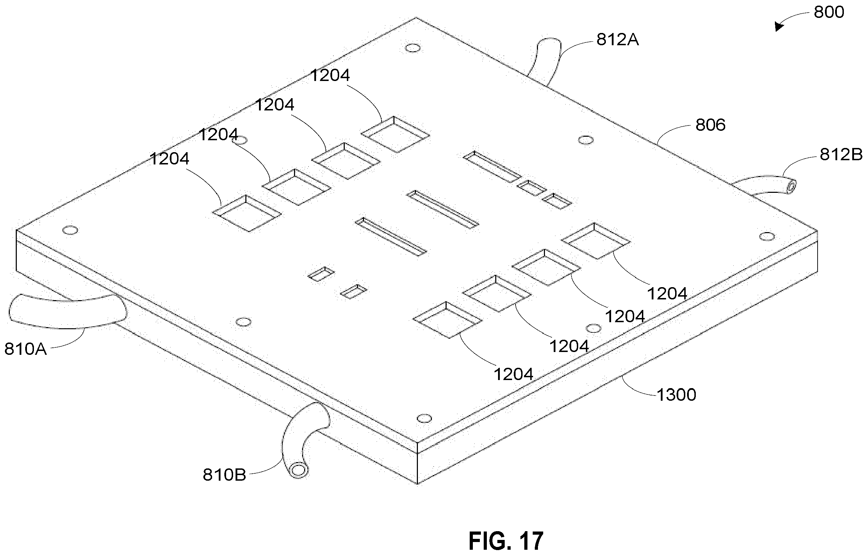

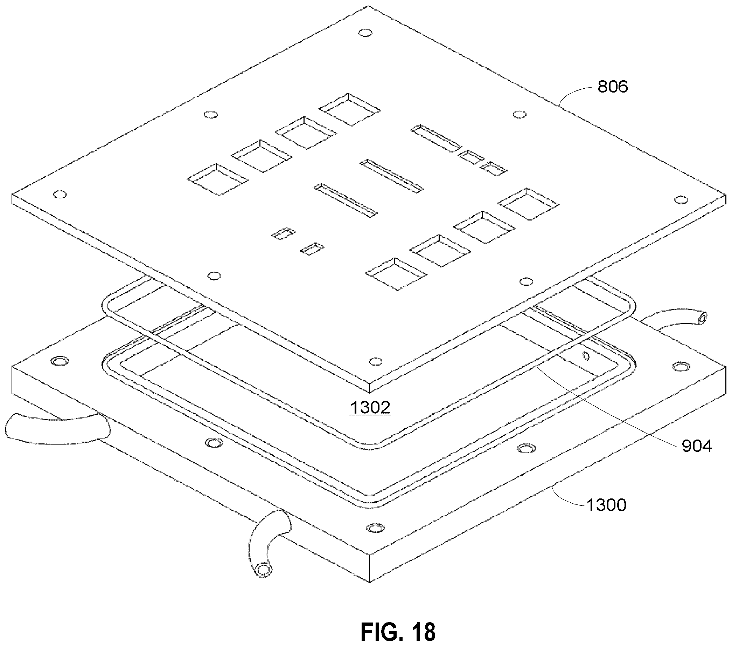

FIG. 17 is a top perspective view of the secondary side cold plate assembly 800 of FIGS. 8-10. FIG. 18 is a top perspective exploded view of the secondary side cold plate assembly of FIGS. 8-10 and 17. In the illustrated examples of FIGS. 17 and 18, the secondary side cold plate assembly 800 includes the stiffener 806 of FIGS. 8-10 and 12, the cold plate housing 1300 of FIGS. 8-10 and 13, the inlets 810A, 810B of FIGS. 8-10 and 13, and the outlets 812A, 812B of FIGS. 8-10 and 13. In the illustrated example of FIGS. 17 and 18, the secondary side cold plate assembly 800 includes multiple separately manufactured components. In other examples, some or all of the components of the secondary side cold plate assembly 800 can be integrally formed.

In the illustrated example of FIGS. 17 and 18, the secondary side cold plate assembly 800 does not include a plate (e.g., the plate 1402 of FIGS. 14A and 14B, etc.) coupled to the cold plate housing 1300. Thus, in this example, the stiffener 806 defines a boundary surface of the flow paths through the cold plate housing 1300. In some examples, the cold plate housing 1300 can include fins that extend into the internal cavity 1302 and can be implemented with one or more of the fin configurations 1500 of FIG. 15. In other examples, the secondary side cold plate assembly 800 can include the plate 1402 of FIGS. 14A and 14B. In some such examples, the top plate 1402 can include fins (e.g., the fins 1406 of FIGS. 14A and 14B, etc.) that extend into the internal cavity 1302 and can be implemented with one or more of the fin configurations 1500 of FIG. 15. While the secondary side cold plate assembly 800 is depicted in FIGS. 17 and 18 as including the cold plate housing 1300 of FIG. 13, in other examples, the secondary side cold plate assembly 800 can include the cold plate housing 1600 of FIG. 16.

FIG. 19A is a schematic diagram of the secondary side cold plate assembly 800 of FIGS. 8-10, 17, and 18 with the stiffener 806 of FIG. 12 in an example first stiffener plate configuration 1900. In the illustrated example of FIG. 19A, the stiffener 806 includes the cavities 1204 of FIG. 12 in which the heat-producing components 1100 of the printed circuit board 802 are disposed. In the first stiffener plate configuration 1900 of FIG. 19A, the cavities 1204 are blind holes, which do not extend fully through the stiffener 806. In some examples, the first stiffener plate configuration 1900 of FIG. 19A may be used when the stiffener 806 is composed of a thermally conductive material (e.g., copper, brass, aluminum, etc.) and the stiffener 806 is able to thermally conduct heat from the heat-producing components 1100 to the cold plate 808. In some examples, the stiffener 806 can be composed of a metal alloy with comparatively moderate thermal conductivity and stiffness. In some such examples, the stiffener 806 including the blind holes 1204 can be formed of a material having a higher stiffness but lower conductivity (e.g., brass).

FIG. 19B is a schematic diagram of the secondary side cold plate assembly 800 of FIGS. 8-10, 17, and 18 with an example stiffener plate 1904 having an example second stiffener plate configuration 1902. The stiffener 1904 is similar to the stiffener 806 of FIGS. 8-11, 12, and 17 except that the stiffener 1904 includes through holes 1906 instead of the cavities 1204 of FIGS. 12 and 19A. In the second stiffener plate configuration 1902 of FIG. 19B, the holes 1906 extend fully through the stiffener 1904. In some examples, the stiffener 1904 including the through holes 1906 is formed from a material having a lower stiffness but high conductivity (e.g., copper) than a material used to form the stiffener 806 including the cavities 1204. In some examples, the stiffener(s) 806, 1904 are formed from an alloy selected to obtain moderate stiffness with moderate high thermal conductivity. Thus, in examples disclosed herein, a composition of the material (e.g., alloy) selected for the stiffener(s) 806, 1904 can selected to balance thermal conductivity while providing for adequate stiffness to reduce deflective stresses on the printed circuit board.

The holes 1906 are shaped to receive heat-producing components 1100 of FIG. 11. In the illustrated example of FIG. 19B, the holes 1906 have a complementary size and shape to the heat-producing components 1100. In other examples, the holes 1906 can be larger than the heat-producing components 1100. In the illustrated example of FIG. 19B, because the holes 1906 are through holes, the heat-producing components 1100 at least partially abut the plate 1402 of the cold plate 808, thereby facilitating the transferring of heat via conduction therebetween. In some examples, the holes 1906 can include thermoelectric cooling modules (TECs) (e.g., Peltier devices, etc.) disposed therein (e.g., TECs having a thin form factor to fit within the holes 1906). In some such examples, a side of the TEC that has a higher temperature during use can be proximate to (e.g., abut, face) the cold plate 808 and a side of the TEC having a lower temperature can be proximate to (e.g., abut, face) the heat producing components 1100.

In some examples, the second stiffener plate configuration 1902 of FIG. 19B can be used when the stiffener plate 1904 is composed of a comparatively less thermally conductive material (e.g., carbon steel, stainless steel, etc.) as compared to the stiffener 806 of FIG. 19A and the stiffener 806 provides for less thermal conduction of heat from the heat-producing components 1100 to the cold plate 808. For instance, the stiffener 1904 can be used when the printed circuit board 802 is expected to experience a comparatively large amount of mechanical stress and a stiffer material for the stiffener is more suitable to provide structural support. As disclosed herein, a material of the stiffener 1902 can be selected to balance thermal conductivity and stiffness properties.

FIG. 19C is a schematic diagram of the secondary side cold plate assembly 800 of FIGS. 8-10, 17 and 18 with the stiffener plate 1904 of FIG. 19B in an example third stiffener plate configuration 1908. The third stiffener plate configuration 1908 is similar to the second stiffener plate configuration of FIG. 19B, except that the stiffener plate 1904 includes example pedestals 1910 disposed between the heat-producing components 1100 and the cold plate 808. The pedestals 1910 facilitate thermal conduction of heat from the heat-producing components 1100 and the cold plate 808. In some examples, ones of the pedestals 1910 can be disposed within the holes 1906 via one or more press-fits within the stiffener plate 1904, one or more chemical adhesives, one or more fasteners, one or more welds. Additionally or alternatively, the pedestals 1910 can be retained via the coupling of the cold plate 808, the stiffener plate 1904, and/or the printed circuit board 802. The pedestals 1910 can be composed of any suitably conductive thermally conductive material, such as copper, silver, and/or aluminum. In some examples, the third stiffener plate configuration 1908 of FIG. 19C can be used when the heat-producing components 1100 are do not abut the cold plate 808 and the stiffener plate 1904 is composed of a comparatively less thermally conductive material (e.g., carbon steel, stainless steel, etc.) and, thus the stiffener 1904 is less able to thermally conduct heat from the heat-producing components 1100 to the cold plate 808. In other examples, the stiffener 1904 can be composed of a metal alloy with comparatively moderate thermal conductivity and stiffness.

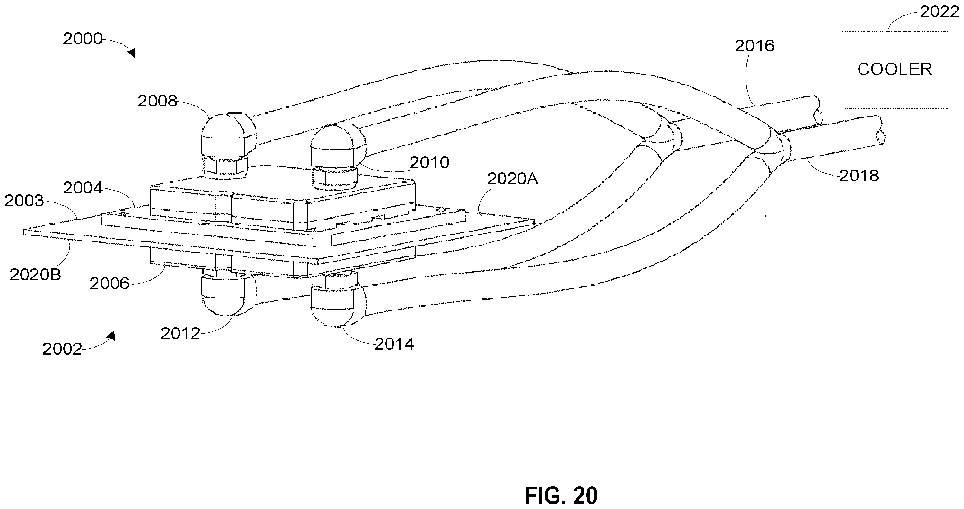

FIG. 20 is a perspective view of an example cooling system 2000 for an example dual-sided cold plate assembly 2002 implemented in accordance with the teachings of this disclosure. In the illustrated example of FIG. 20, the dual-sided cold plate assembly 2002 is coupled to an example printed circuit board 2003 and includes an example primary side cold plate assembly 2004 and an example secondary side cold plate assembly 2006. In the illustrated example of FIG. 20, the primary side cold plate assembly 2004 includes a first inlet 2008 and a first outlet 2010. In the illustrated example of FIG. 20, the secondary side cold plate assembly 2006 includes a second inlet 2012 and a second outlet 2014. In the illustrated example of FIG. 20, the inlets 2008, 2012 are fluidly coupled to a first coolant conduit 2016 and the outlets 2010, 2014 are fluidly coupled to a second coolant conduit 2018.

In the illustrated example of FIG. 20, the printed circuit board 2003 includes a primary side 2020A and a secondary side 2020B. The printed circuit board 2003 includes one or more heat-producing components. For example, the printed circuit board 2003 can include one or more integrated circuits, FETS, and/or VRS. In some examples, the secondary side 2020B of the printed circuit board 2003 can be coupled to another baseboard, such as a universal baseboard and/or a motherboard. In some examples, the printed circuit board 2003 can be implemented by the printed circuit board 101 of FIG. 1 and/or the printed circuit board 802 of FIGS. 8-11.

The dual-sided cold plate assembly 2002 dissipates heat produced by one or more heat-generating components of the printed circuit board 2003. In the illustrated example of FIG. 20, the primary side cold plate assembly 2004 is coupled to the primary side of the printed circuit board 2003 and the secondary side cold plate assembly 2006 is coupled to the secondary side of the printed circuit board 2003. In the illustrated example of FIG. 20, the primary side cold plate assembly 2004 and the secondary side cold plate assembly 2006 of the dual-sided cold plate assembly 2002 are arranged in a sandwich configuration. In some examples, the secondary side cold plate assembly 2006 can be implemented by the secondary side cold plate assembly 800 of FIGS. 8-10, the first stiffener subassembly 300 of FIG. 3A, and/or the second stiffener subassembly 310 of FIG. 3B. In the illustrated example of FIG. 20, the primary side cold plate assembly 2004 and the secondary side cold plate assembly 2006 are implemented by a same cold plate assembly. In other examples, the primary side cold plate assembly 2004 can be implemented by another cold plate at least partially different from the secondary side cold plate assembly 2006. For instance, the primary side cold plate assembly 2004 can be larger (e.g., receive a greater volume of coolant, etc.) than the secondary side cold plate assembly 2006 due to the greater packaging space that is typically available on the primary side of a printed circuit board.

The coolant conduits 2016, 2018 fluidly connect the cold plate assemblies 2004, 2006. In some examples, one or both of the coolant conduits 2016, 2018 can be flexible non-conductive tubes (e.g., rubber tubes, plastic tubes, etc.). Additionally or alternatively, one or both of the coolant conduits 2016, 2018 can be rigid or substantially rigid tubes (e.g., metal piping, plastic tubes, etc.). In the illustrated example of FIG. 20, the coolant conduits 2016, 2018 are Y-connectors. In other examples, one or both of the coolant conduits 2016 can have any other suitable shape (e.g., depending on the location and quantity of the inlets 2008, 2012 and/or the outlets 2010, 2014, etc.).

In the illustrated example of FIG. 20, the coolant conduits 2016, 2018 are coupled to the inlets 2008, 2012 and the outlets 2010, 2014, respectively. In the illustrated example of FIG. 20, the first inlet 2008 and the first outlet 2010 are received by surface of the primary side cold plate assembly 2004 (e.g., an uppermost surface of the primary side cold plate assembly 2004 when oriented as shown in FIG. 20) and the second inlet 2012 and the second outlet 2014 are received by a surface of the secondary side cold plate assembly 2006 (e.g., a bottommost surface of the secondary side cold plate assembly 2006 when oriented as shown in FIG. 20). In other examples, some or all of the inlets 2008, 2012, and/or the outlets 2010, 2014 can be disposed at a different location on the cold plate assemblies 2004, 2006.

During operation, coolant leaves a coolant source or a cooler 2022. The cooler 2022 controls (e.g., chills) a temperature of the coolant flowing through the cooling system 2000. In some examples, the cooler 2022 can include one or more closed-loop heat exchangers, one or more radiators, one or more chillers, and/or one or more coolant distribution units (CDU). In some such examples, the cooler 2022 can be a four-fan closed-loop crossflow heat exchanger. In other examples, the cooler 2022 can be absent. In some such examples, the first coolant conduit 2016 can be coupled to a facility coolant source (e.g., a municipal water supply, etc.) and the second coolant conduit 2018 can be coupled to a facility coolant drain (e.g., a wastewater system, etc.).

During operation, the coolant leaves the cooler 2022 through the first coolant conduit 2016 and flows into the cold plate assemblies 2004, 2006 via the inlets 2008, 2012, respectively. After entering the cold plate assemblies 2004, 2006 the coolant flows through respective internal flow paths (not illustrated) of the cold plate assemblies 2004, 2006 and absorbs heat via convection therefrom. In some examples, the internal flow paths of the cold plate assemblies 2004, 2006 can include one or more of the fin configurations 1500 of FIG. 15 and/or the internal wall structure 1602 of FIG. 16. In the illustrated example of FIG. 20, the coolant conduits 2016, 2018 distribute an equal amount of coolant to the cold plate assemblies 2004, 2006. In other examples, the coolant conduits 2016, 2018 can be configured via geometry and/or one or more controllable features (e.g., valves or other flow rate control mechanisms) to deliver different amounts of coolant to the cold plate assemblies 2004, 2006. For example, one or more controllable features (e.g., valves, etc.) can be modulated (e.g., opened, closed, etc.) to shut-off flow to the secondary side cold plate assembly 2006 when secondary side cooling is not needed (e.g., based on work load(s) of the heat-generating components of the printed circuit board 2003 at a given time). After leaving the cold plate assemblies 2004, 2006 via the outlets 2010, 2014, the coolant returns to the cooler 2022 via the second coolant conduit 2018.

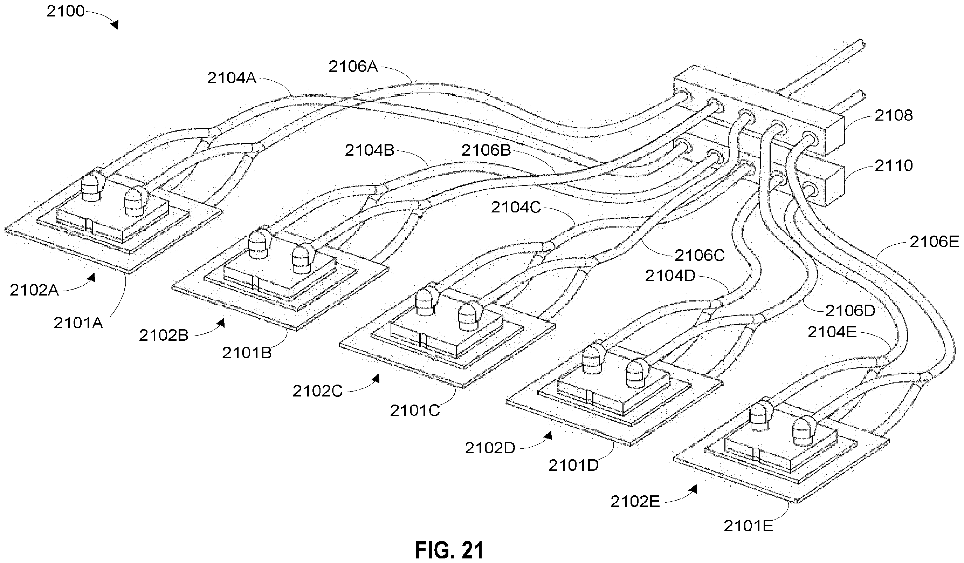

FIG. 21 is a perspective view of an example array 2100 of example printed circuit boards including an example first printed circuit board 2101A, an example second printed circuit board 2101B, an example third printed circuit board 2101C, an example fourth printed circuit board 2101D, and an example fifth printed circuit board 2101E. In the illustrated example of FIG. 21, the printed circuit boards 2101A, 2101B, 2101C, 2101D, 2101E are cooled by an example first dual-sided cold plate assembly 2102A, an example second dual-sided cold plate assembly 2102B, an example third dual-sided cold plate assembly 2102C, an example fourth dual-sided cold plate assembly 2102D, and an example fifth dual-sided cold plate assembly 2102E, respectively. In the illustrated example of FIG. 21, the first dual-sided cold plate assembly 2102A receives and expels coolant via an example first inlet coolant conduit 2104A and an example first outlet coolant conduit 2106A, the second dual-sided cold plate assembly 2102B receives and expels coolant via an example second inlet coolant conduit 2104B and an example second outlet coolant conduit 2106B, the third dual-sided cold plate assembly 2102C receives and expels coolant via an example third inlet coolant conduit 2104C and an example third outlet coolant conduit 2106C, the fourth dual-sided cold plate assembly 2102D receives and expels coolant via an example fourth inlet coolant conduit 2104D and an example fourth outlet coolant conduit 2106D, and the fifth dual-sided cold plate assembly 2102E receives and expels coolant via an example fifth inlet coolant conduit 2104E and an example fifth outlet coolant conduit 2106E. In the illustrated example of FIG. 21, the inlet coolant conduits 2104A, 2104B, 2104C, 2104D, 2104E are coupled to an example inlet manifold 2108 and the outlet coolant conduits 2106A, 2106B, 2106C, 2106E are coupled to an example inlet manifold 2110. In some examples, the manifolds 2108, 2110 can be coupled to a case and/or server rack associated with the array 2100. In some examples, the manifolds 2108, 2110 can be an integral component.

In some examples, each of the printed circuit boards 2101A, 2101B, 2101C, 2101D, 2101E are similar to the printed circuit board 2003 of FIG. 20. In other examples, some or all of the printed circuit boards 2101A, 2101B, 2101C, 2101D, 2101E can be implemented by any suitable printed circuit board. In some examples, one or more of the printed circuit boards 2101A, 2101B, 2101C, 2101D, 2101E are absent. In some such examples, some or all of the printed circuit boards 2101A, 2101B, 2101C, 2101D, 2101E can include multiple receptacles to receive one or more of the dual-sided cold plate assemblies 2102A, 2102B, 2102C, 2102D, 2102E. In some such examples, some or all of the printed circuit boards 2101A, 2101B, 2101C, 2101D, 2101E is a UBB. Thus, in some examples, two or more dual-sided cold plate assemblies 2102A, 2102B, 2102C, 2102D, 2102E can be carried by a single printed circuit board (e.g., one of the printed circuit boards 2101A, 2101B, 2101C, 2101D, 2101E) including, for instance, two or more sockets. In some examples, two or more of the printed circuit boards including two or more of the dual-sided cold plate assemblies 2102A, 2102B, 2102C, 2102D, 2102E can be supported by a UBB.

In some examples, each of the dual-sided cold plate assemblies 2102A, 2102B, 2102C, 2102D, 2102E are similar to the cooling system 2000 of FIG. 20 (e.g., include a symmetrical sandwich configuration, etc.). In other examples, some or all of the dual-sided cold plate assemblies 2102A, 2102B, 2102C, 2102D, 2102E can be implemented by any other suitable dual-sided cold plate assembly(ies). In some examples, each of the inlet coolant conduits 2104A, 2104B, 2104C, 2104D, 2104E can be implemented by the coolant conduit 2016 of FIG. 20 and each of the outlet coolant conduits 2106A, 2106B, 2106C, 2106D, 2106E can be implemented by the outlet coolant conduit 2018 of FIG. 20. In some examples, some or all of the inlet coolant conduits 2104A, 2104B, 2104C, 2104D, 2104E can include controllable features (e.g., valves, etc.) to modulate coolant flow between different ones of the dual-sided cold plate assemblies 2102A, 2102B, 2102C, 2102D, 2102E and/or between sides of some or all of the dual-sided cold plate assemblies 2102A, 2102B, 2102C, 2102D, 2102E (e.g., between the primary side cold plates and secondary side cold plates of the dual-sided cold plate assemblies 2102A, 2102B, 2102C, 2102D, 2102E, etc.).

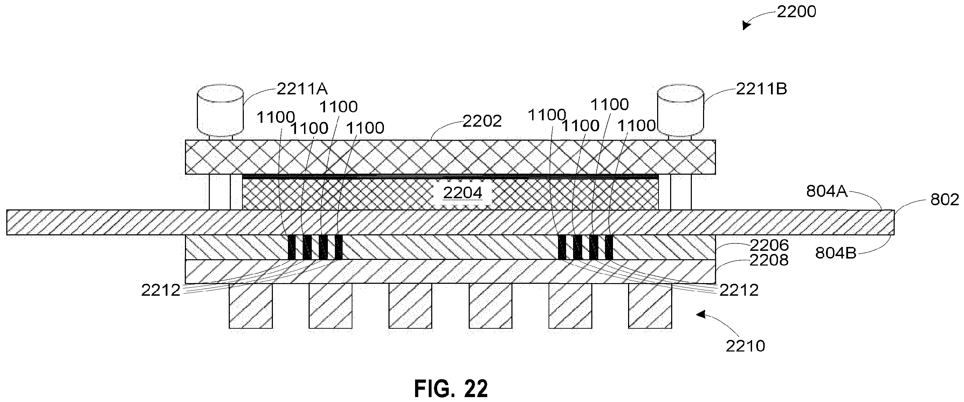

FIG. 22 is a schematic diagram of another example cooling assembly 2200 coupled to the printed circuit board 802 of FIG. 8 and implemented in accordance with the teachings of this disclosure. The printed circuit board 802 includes the primary side 804A and the secondary side 804B of FIG. 8. In the illustrated example of FIG. 22, the printed circuit board 802 includes the heat-producing components 1100 of FIG. 11. In the illustrated example of FIG. 22, the cooling assembly 2200 includes an example integrated circuit package 2204 coupled to the primary side 804A of the printed circuit board 802 and an example primary side cooling system 2202 to facilitate cooling of the integrated circuit package 2204. In the illustrated example of FIG. 22, the cooling assembly 2200 includes an example first stiffener layer 2206, an example second stiffener layer 2208, and example fins 2210 coupled to the secondary side 804B of the printed circuit board 802.

The integrated circuit package 2204 is compute component coupled to the primary side 804A of the printed circuit board 802. In some examples, the integrated circuit package 2204 can be implemented by a CPU, a GPU, an accelerator, etc. In the illustrated example, the primary side cooling system 2202 abuts the integrated circuit package 2204 and dissipates heat therefrom. The example primary side cooling system 2202 can be implemented by any suitable cold plate assembly (e.g., the first cold plate 302 of FIG. 3A, the cold plate 312 of FIG. 3B, the secondary side cold plate assembly 800 of FIGS. 8-10, etc.) and/or heat sink.

In the illustrated example of FIG. 22, the primary side cooling system 2202 and the integrated circuit package 2204 are retained to the printed circuit board 802 via an example first fastener 2211A and an example second fastener 2211B. The fasteners 2211A, 2211B are retention mechanisms that extend through the primary side cooling system 2202, the integrated circuit package 2204, and the stiffener layers 2206, 2208 such that the primary side cooling system 2202, the integrated circuit package 2204, and the stiffener layers 2206, 2208 are coupled together. In some examples, the tightening of the fasteners 2211A, 2211B exerts a bending moment on the primary side cooling system 2202 and the integrated circuit package 2204, which is resisted by the stiffener layers 2206, 2208.

In the illustrated example of FIG. 22, the fins 2210 facilitate convection between the secondary side 804B of the printed circuit board 802 and an incident airflow. In some examples, the fins 2210 can define one or more spaced channels. In other examples, the fins 2210 can have any other suitable configuration (e.g., similar to one or more of the fin configurations 1500 of FIG. 15, etc.). In some examples, a fan (e.g., disposed in a housing containing the assembly 2200, etc.) can cause an air flow over the fins 2210. The first stiffener layer 2206 and the second stiffener layer 2208 serve as stiffeners for the assembly 2200 and/or a baseplate of the integrated circuit package 2204. The first stiffener layer 2206 and the second stiffener layer 2208 of the cooling assembly 2200 provide for stiffness and thermal conductivity, respectively. That is, in some examples, the first stiffener layer 2206 is composed of a relatively stiff material (e.g., stainless steel, cast iron, carbon steel, etc.) and the second stiffener layer 2208 is composed of a relatively thermally conductive material (e.g., copper, aluminum, brass, etc.).

In the illustrated example of FIG. 22, the first stiffener layer 2206 includes example openings 2212, in which the heat-producing components 1100 of the printed circuit board 802 are disposed. In the illustrated example of FIG. 22, the openings 2212 are through holes (e.g. similar to the through holes 1906), which fully extend through the first stiffener layer 2206. In the illustrated example of FIG. 22, because the openings 2212 are through holes, the heat-producing components 1100 at least partially abut the second stiffener layer 2208, thereby facilitating the transferring of heat via conduction therebetween. Additionally or alternatively, the cooling assembly 2200 can include pedestals disposed between the heat-producing components 1100 and the second stiffener layer 2208 in some or all of the openings 2212 (e.g., similar to the pedestals 1910 of FIG. 19C, etc.). to provide for thermal conduction of heat from the heat-producing components 1100 to the second stiffener layer 2208.

In some examples, the first stiffener layer 2206 and the second stiffener layer 2208 can be joined via one or more welds (e.g., friction welds, etc.), via one or more fasteners, via one or more chemical adhesives, via one or more interferences fits, etc. In some examples, the example fins 2210 and the second stiffener layer 2208 can be integral components. In some such examples, the fins 2210 can be formed by removing material from the second stiffener layer 2208. In other such examples, the fins 2210 and the second stiffener layer 2208 can be formed via additive manufacturing. In some examples, the fins 2210 and the second stiffener layer 2208 can be manufactured separately and joined via one or more welds, one or more fasteners, one or more chemical adhesives, one or more interference fits, etc.

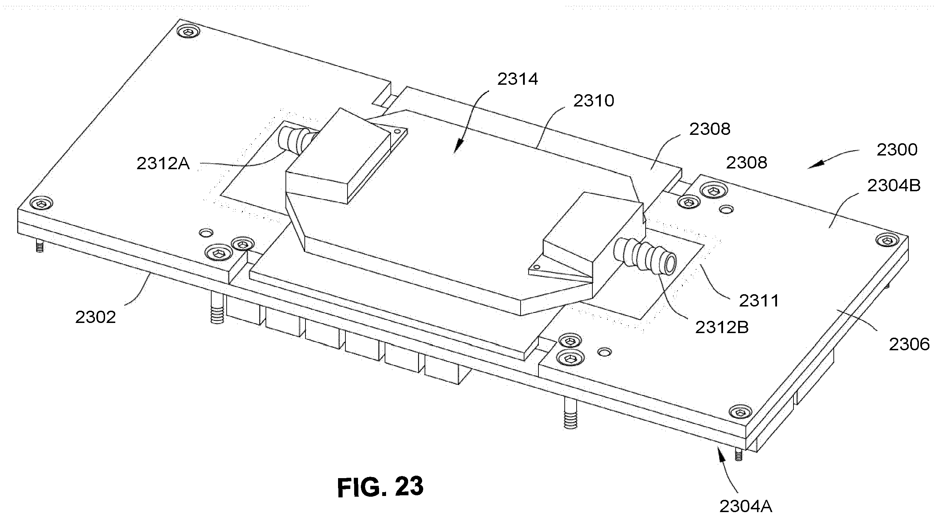

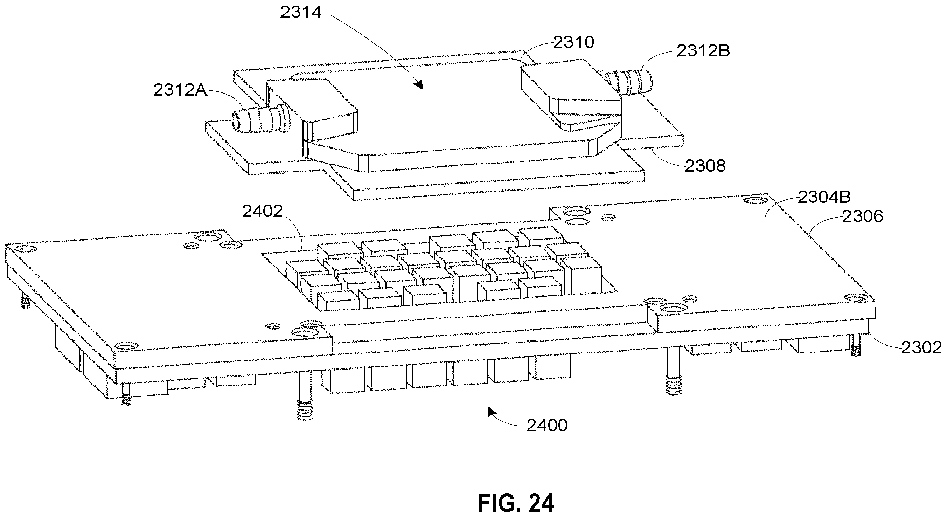

FIG. 23 is a perspective view of another secondary side cold plate cooling assembly 2300 coupled to an example printed circuit board 2302 implemented in accordance with the teachings of this disclosure. FIG. 24 is an exploded perspective view of the secondary side cold plate cooling assembly 2300 of FIG. 23. In the illustrated examples of FIG. 23 and 24, the printed circuit board 2302 has an example primary side 2304A and a secondary side 2304B. In the illustrated example of FIGS. 23 and 24, the secondary side cold plate cooling assembly 2300 includes an example stiffener plate 2306, an example base 2308, and an example cold plate housing 2310.

The printed circuit board 2302 includes one or more heat-producing components. For example, the printed circuit board 2302 can include one or more integrated circuits, FETS, and/or VRs. In some examples, the secondary side 2304B of the printed circuit board 2302 can be coupled to another baseboard, such as a universal baseboard and/or a motherboard. In some examples, the printed circuit board 2003 can be implemented by the printed circuit board 101 of FIG. 1, the printed circuit board 802 of FIGS. 8-11, and/or the printed circuit board 2003 of FIG. 20. In some examples, an integrated circuit package (e.g., a CPU, a GPU, an accelerator, etc.) can be coupled to the primary side 2304A of the printed circuit board 2302, which produces heat during operation.

In the illustrated example of FIG. 24, example heat-producing components 2400 are disposed on an example secondary side 2304B of the printed circuit board 2302. In some examples, the heat-producing components 2400 are similar to the heat-producing components 1100 of FIG. 11. In the illustrated example of FIG. 24, the stiffener plate 2306 includes an example opening 2402 to receive heat-producing component(s) 1100 such that the heat-producing component(s) 1100 at least partially abut the base 2308. In the illustrated of FIG. 24, the stiffener plate 2306 includes a single aperture (e.g., the opening 2402, etc.). In other examples, the stiffener plate 2306 can include multiple holes that receive corresponding ones of the heat-producing components 1100, similar to the holes 1906 of FIG. 19A.

In some examples, the stiffener plate 2306 is composed of a relatively stiff material (e.g., stainless steel, cast iron, carbon steel, etc.) and the base 2308 is composed of a relatively thermally conductive material (e.g., copper, aluminum, brass, etc.). The two-material construction of the secondary side cold plate cooling assembly 2300 enables the stiffener 2306 to resist deformation associated with the coupling of the assembly 2300 and conduct heat produced by the heat-producing components 1100.

In the illustrated example of FIG. 23, corresponding surfaces of the stiffener plate 2306 and the base 2308 are flush. In other examples, the corresponding surfaces of the stiffener plate 2306 and the base 2308 can have any other suitable relationship. In the illustrated example of FIG. 23, the stiffener plate 2306 and the base 2308 are coupled via an example weld 2311. In some examples, the weld 2311 can be a friction stir weld and/or an electron beam weld. In other examples, the weld 2311 can be implemented by any suitable type of weld. Additionally or alternatively, the stiffener plate 2306 and the base 2308 can be coupled by one or more fasteners, one or more chemical adhesives, one or more interference fits, etc.

The cold plate housing 2310 includes an example inlet 2312A and an example outlet 2312B. In the illustrated example of FIGS. 23 and 24, the inlet 2312A and the outlet 2312B are disposed on opposite sides of the cold plate housing 2310. The inlet 2312A and the outlet 2312B define an example coolant pathway 2314 through which coolant can flow through the cold plate housing 2310. In some examples, the internal coolant pathway 2314 can include one or more channels (e.g., microchannels, etc.), one or more external fins (e.g., having one or more of the fin configurations 1500 of FIG. 15, etc.), and/or one or more internal wall instructions that increase the surface area of the internal coolant pathway 2314 exposed to the flow of coolant. In some examples, the cold plate housing 2310 can have multiple inlets and outlets in addition to the inlet 2312A and the outlet 2312B. In some such examples, each pair of inlets and outlets can define a corresponding coolant pathway through the cold plate housing 2310. During the operation of the secondary side cold plate cooling assembly 2300, the cold plate housing 2310 conducts heat from the heat-producing components of the printed circuit board 2302. Also, coolant flows into the inlet 2312A through the coolant pathway 2314, and out of the outlet 2312B.The coolant absorbs heat from the cold plate 2310, thereby cooling the cold plate housing 2310 and the heat-producing components of the printed circuit board 2302.

In the illustrated example of FIGS. 23 and 24, the cold plate housing 2310 and the base 2308 are integral components. In some such examples, the cold plate housing 2310 and the base 2308 can be manufactured via additive manufacturing. In other examples, the cold plate housing 2310 and the base 2308 can be manufactured separately and joined via one or more welds, one or more fasteners, one or more chemical adhesives, one or more interference fits, etc. In some such examples, the base 2308 can include holes to receive fasteners to facilitate the coupling of the cold plate housing 2310 and the base 2308. In some examples, the cold plate housing 2310 can include a groove to receive a seal (e.g., the 904 of FIG. 9, etc.) to prevent coolant escape via the interface between the cold plate housing 2310 and the base 2308.

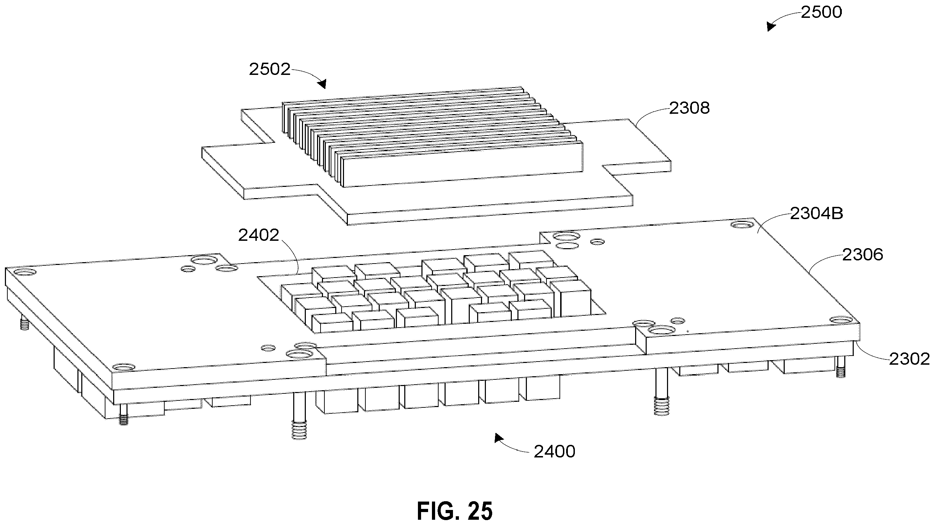

FIG. 25 is a perspective exploded view of an example secondary side heat sink assembly 2500 implemented in accordance with the teachings of this disclosure. In the illustrated example of FIG. 25, the secondary side heat sink assembly 2500 includes the printed circuit board 2302 of FIGS. 23 and 24, the stiffener plate 2306 of FIGS. 23 and 24, an example base 2308 of FIGS. 23 and 24, and an example fins 2502. The example secondary side heat sink assembly 2500 is similar to the secondary side cold plate cooling assembly 2300 of FIGS. 23 and 24, except that the secondary side heat sink assembly 2500 is a heat-sink. Also, the secondary skid heat sink assembly 2500 includes example fins 2502 instead of the cold plate housing 2310. In the illustrated example of FIG. 25, the fins 2502 are similar to the fins 2210 of FIG. 22. In some examples, the fins 2502 facilitate cooling of the printed circuit board 2302 via air-based convection. In other examples, the example fins 2502 can be used in connection with a liquid-based cooling system. For example, the fins 2502 can define an internal flow path of the cold plate housing 2310 of FIGS. 24 and 25. In some such examples, the fins 2502 can be aligned with the inlet and outlet of the cold plate housing (e.g., the inlet 2312A of FIG. 23, the outlet 2312B of FIG. 23, etc.) to facilitate the distribution of coolant throughout the cold plate hosing 2310. Thus, in some examples, the secondary side heat sink assembly 2500 can provide for air-based cooling or liquid-based cooling. The use of the secondary side heat sink assembly 2500 for air-based cooling or liquid-based cooling can be based on, for example, power consumption at the printed circuit board.

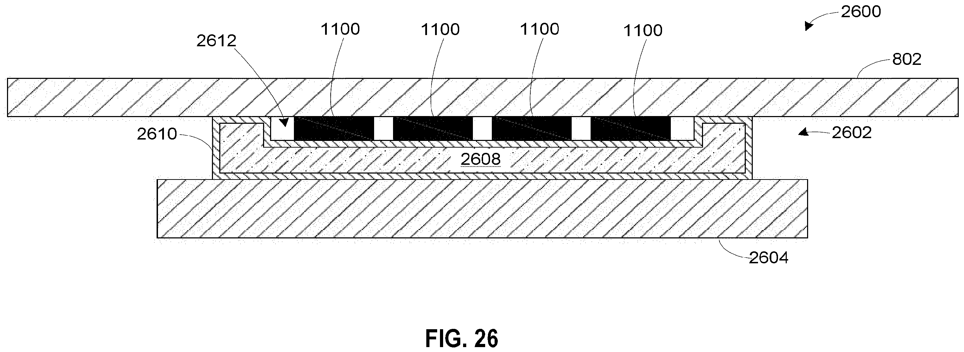

FIG. 26 is a schematic diagram of an example assembly 2600 that includes another example stiffener 2602. In the illustrated example of FIG. 26, the example assembly 2600 includes the example printed circuit board 802 of FIG. 2 and an example cooling system 2604. In the illustrated example of FIG. 26, the printed circuit board 802 includes the heating-producing components 1100 of FIG. 11. The example cooling system 2604 can be implemented by any suitable cold plate assembly (e.g., the first cold plate 302 of FIG. 3A, the cold plate 312 of FIG. 3B, the secondary side cold plate assembly 800 of FIGS. 8-10, the cold plate housing 2310 of FIG. 23, etc.) and/or a heat sink (e.g., the fins 2502 of FIG. 25, etc.).

In the illustrated example of FIG. 26, the stiffener 2602 includes an example core portion 2608 and an example thermal interface layer 2610. In the illustrated example of FIG. 26, an opening 2612 is defined in the core portion 2608. The opening 2612 receives the heat-producing components 1100 of the printed circuit board 802. In the illustrated example of FIG. 26, the opening 2612 is a cutout formed on a surface of the stiffener 2602 (e.g., a top surface when the stiffener 2602 is oriented as in FIG. 26) adjacent to the secondary side 804B of the printed circuit board 802. The thermal interface material layer 2610 at least partially surrounds the opening 2612 (e.g., lines the core portion 2608, etc.) to facilitate the transfer of heat between the heat-producing components 1100. Although in the example of FIG. 26, the opening 2612 receives multiple heat-producing components 1100, in other examples, the stiffener 2602 can include multiple openings that receive one or more of the heat-producing components 1100 of FIG. 11 (e.g., similar to the plurality of holes 1102 of FIG. 11, similar to the plurality of holes 1906 of FIG. 19, etc.). The two-part stiffener construction (e.g., the core portion 2608 and the thermal interface 2610) of the assembly 2600 enables the stiffener 2602 to resist deformation associated with the coupling of the assembly 2600 and conduct heat produced by the heat-producing components 1100 to the cooling system 2604.

In some examples, the core portion 2608 is composed of a relatively stiff material (e.g., stainless steel, cast iron, carbon steel, etc.) and the thermal interface material layer 2610 is composed of a relatively thermally conductive material (e.g., copper, aluminum, brass, etc.). In some examples, the thermal interface material layer 2610 conducts heat from the heat-producing components 1100 laterally (e.g., to the side walls of the stiffener 2602, etc.) and vertically (e.g., along the side walls to the surface of the stiffener 2602 abutting the assembly 2600, etc.). In some examples, the stiffener 2602 can be manufactured by negative manufacturing techniques applied to the core portion 2608 from a stock material (e.g., machining, etc.) and plating (e.g., electroplating, etc.) the thermal interface material layer 2610 onto the core portion 2608. In other examples, the stiffener 2602 can be manufactured by any other suitable negative manufacturing techniques and/or additive manufacturing techniques.

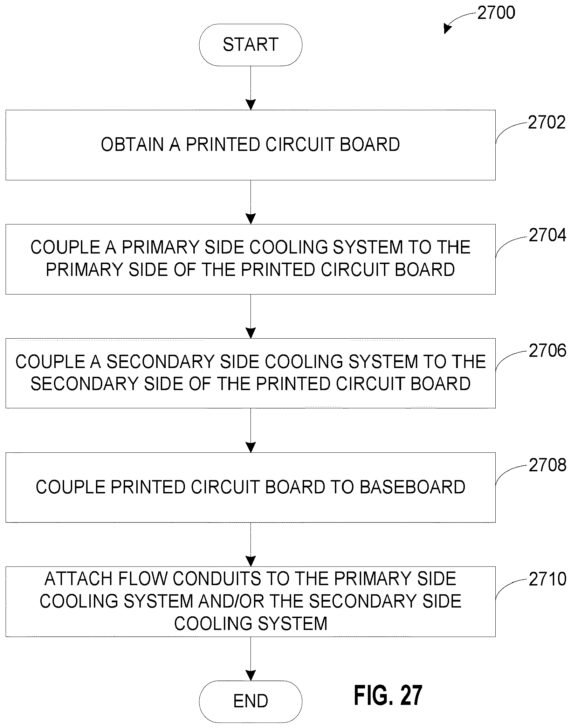

FIG. 27 is a flow diagram of an example method 2700 that can be used to assemble printed circuit board including a secondary side cold plate assembly in accordance with the teachings of this disclosure. At block 2702, a printed circuit board is obtained. For example, the printed circuit board 101 of FIG. 1, the printed circuit board 802 of FIG. 8, and/or the printed circuit board 2302 of FIG. 23 can be obtained. At block 2704, a primary side cooling system is coupled to a first (e.g., primary side) the printed circuit board. For example ,a primary side cooling system (e.g., the primary side cooling system 2202 of FIG. 22, etc.) can be coupled to a first side of the printed circuit board 2302 via one or more fasteners, one or more interference fits, etc. In particular, the first side of the printed circuit board 2302 corresponds to a side of the printed circuit board 2302 distal to a baseboard when the printed circuit board is coupled to the baseboard. In some examples, the primary side cooling system can be implemented by any suitable cold plate assembly (e.g., the first cold plate 302 of FIG. 3A, the cold plate 312 of FIG. 3B, the secondary side cold plate assembly 800 of FIGS. 8-10, etc.) and/or heat sink. At block 2706, a secondary side cooling system is coupled to a secondary side of the printed circuit board opposite the first or primary side. In some examples, the secondary side cooling system can be implemented by any suitable cold plate assembly (e.g., the secondary side cold plate assembly 800 of FIGS. 8-10, the first stiffener subassembly 300 of FIG. 3A, and/or the second stiffener subassembly 310 of FIG. 3B, etc.). In other examples, the secondary side cooling system can be implemented by a heat sink. In some examples, the primary side cooling system and the secondary side cooling system are implemented by a same type of cold plate assembly. At block 2708, the printed circuit board is coupled to a baseboard. For example, the printed circuit board can be coupled to a baseboard (e.g., the baseboard 200 of FIG. 2, etc.) via one or more fasteners, one or more interference fits, etc.). At block 2710, flow conduits are attached to the primary side cooling system and/or the secondary side cooling system. For example, flow conduits can be attached to (1) couple the primary side cooling system to the secondary side cooling system, (2) couple the primary side cooling system and/or the secondary side cooling system to the cooling system of an adjacent printed circuit board, and/or (3) couple the primary side cooling system and/or the secondary side cooling system to a coolant source. The operations 2700 end.

Although the example operations 2700 are described with reference to the flowchart illustrated in FIG. 27, many other methods of assembling an assembly implemented in accordance with the teachings of this disclosure may alternatively be used. For example, the order of execution of the blocks may be changed, and/or some of the blocks described may be changed, eliminated, or combined.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

From the foregoing, it will be appreciated that example apparatus, systems, methods, and articles of manufacture have been disclosed that provide for cooling of printed circuit boards and/or electronic components carried by the printed circuit boards via cooling systems (e.g., cold plate(s)) coupled to a secondary side of the printed circuit board. The cooling systems located at the secondary side of the printed circuit board can provide for additional cooling at the printed circuit board (e.g., in addition to cooling provided via cooling systems located at an opposing or primary side of the printed circuit board)..The use of secondary side cooling systems can reduce a size of the cooling system(s) (e.g., cold plate(s)) provided on the primary side of printed circuit boards. Example cooling system(s) disclosed herein can be carried by, for example, stiffeners coupled to the secondary side of the printed circuit board, thereby providing for increased cooling while accommodating a form factor of the printed circuit board and/or available real estate (e.g., when the printed circuit board is coupled to baseboard). In some examples, electronic components can be located at the secondary side of the printed circuit board in view of the cooling provided at the secondary side. Disclosed examples herein increase the total cooling capability achieved at the printed circuit board, which can enable more powerful processing performance by the electronic component(s) of the printed circuit boards.

Secondary side cold plates for printed circuit boards are disclosed herein. Further examples and combinations thereof include the following:
Example 1 includes an apparatus comprising a first printed circuit board, a second printed circuit board coupled to the first printed circuit board, the second printed circuit board having a first side and a second side opposite the first side, the second side facing the first printed circuit board, and a cold plate coupled to the second side of the second printed circuit board.
Example 2 includes the apparatus of example 1, further including a stiffener coupled to the second side of the second printed circuit board.
Example 3 includes the apparatus of example 2, wherein the stiffener includes the cold plate.
Example 4 includes the apparatus of example 2, wherein the stiffener includes an opening defined therein and wherein the second printed circuit board includes a heat-producing component at least partially disposed in the opening.
Example 5 includes the apparatus of example 1, wherein the cold plate is a first cold plate, further including a second cold plate disposed on the first side of the second printed circuit board.
Example 6 includes the apparatus of example 5, wherein the first cold plate includes a first inlet and the second cold plate includes a second inlet to be fluidly coupled to a coolant source, a first outlet to be fluidly coupled to the coolant source, and a second outlet fluidly coupled to the first inlet.
Example 7 includes the apparatus of example 5, wherein the first cold plate and the second cold plate are independently coupled to a coolant source.
Example 8 includes a system comprising a first printed circuit board, a second printed circuit board coupled to the first printed circuit board, a third printed circuit board coupled to the first printed circuit board, a first cold plate disposed between the first printed circuit board and the second printed circuit board, and a second cold plate disposed between the first printed circuit board and the third printed circuit board.
Example 9 includes the system of example 8, wherein the first cold plate includes a first inlet and a first outlet, the second cold plate includes a second inlet and a second outlet, and the first outlet is fluidly coupled to the second outlet.
Example 10 includes the system of example 9, further including a fourth printed circuit board coupled to the first printed circuit board, and a third cold plate disposed between the first printed circuit board and the fourth printed circuit board, the third cold plate including a third inlet fluidly coupled to the second outlet, wherein the first inlet is fluidly coupled to a liquid coolant source.
Example 11 includes the system of example 10, wherein the second printed circuit board, the third printed circuit board, and the fourth printed circuit board are disposed linearly on the first printed circuit board.
Example 12 includes the system of example 8, wherein the first cold plate is coupled to a first side of the second printed circuit board and including a third cold plate, the third cold plate coupled to a second side of the second printed circuit board opposite the first side.
Example 13 includes the system of example 12, wherein the first cold plate includes a first inlet and a first outlet, the third cold plate a second inlet and a second outlet, and the first outlet is fluidly coupled to the second outlet.
Example 14 includes the system of example 12, wherein the first cold plate includes a first inlet and a first outlet, and the third cold plate a second inlet and a second outlet, and further including an inlet manifold, an outlet manifold, a first coolant conduit including a first end coupled to the first inlet, a second end coupled to the second inlet, a third end coupled to the inlet manifold, and a second coolant conduit, a fourth end coupled to the first outlet, a fifth end coupled to the second outlet, and a sixth end coupled to the outlet manifold.
Example 15 includes an apparatus comprising a printed circuit board having a primary side and a secondary side, a stiffener plate coupled to the secondary side, and a cold plate carried by the stiffener plate.
Example 16 includes the apparatus of example 15, wherein the stiffener plate includes an opening defined in a surface of the stiffener plate, the surface adjacent the printed circuit board, and the printed circuit board includes a heat-generating component at least partially disposed in the opening.
Example 17 includes the apparatus of example 16, wherein the surface is a first surface and the opening extends through the stiffener plate to a second surface of the stiffener plate, the second surface opposite the first surface.
Example 18 includes the apparatus of example 15, wherein the cold plate includes an inlet, an outlet, a housing defining a cavity, the inlet and the outlet defining a coolant pathway in through the cavity, and a plate coupled to the housing and proximate to the stiffener..
Example 19 includes the apparatus of example 18, wherein the housing and the plate are integrally formed.
Example 20 includes the apparatus of example 18, wherein the housing includes a groove defined therein and further including a seal disposed in the groove.
Example 21 includes the apparatus of example 18, wherein the plate includes a plurality of fins extending into the cavity.
Example 22 includes the apparatus of example 18, wherein the housing includes a plurality of walls segmenting the cavity into a first section and a second section, the coolant pathway extending through the first section and the second section.
Example 23 includes the apparatus of example 15, wherein the stiffener plate includes a core composed of a first material, and a shell partially encompassing the core, the shell abutting the printed circuit board and the cold plate, the shell composed of a second material more thermally conductive the first material.
Example 24 includes an apparatus comprising a printed circuit board having a first side and a second side, the second side opposite the first side, first means for dissipating heat from the printed circuit board, the first means for dissipating heat from the printed circuit board coupled to the first side, second means for dissipating heat from the printed circuit board, the second means for dissipating heat from the printed circuit board coupled to the second side, and a stiffener disposed between the printed circuit board and the second means for dissipating heat, the stiffener including a first layer abutting the printed circuit board, the first layer composed of a first material, and a second layer abutting the second means for dissipating heat, the second layer composed of a second material more thermally conductive than the first layer.
Example 25 includes the apparatus of example 24, wherein the first material has a higher elastic modulus than the second material.
Example 26 includes the apparatus of example 24, wherein the second means for dissipating heat is carried by a portion of the second layer.
Example 27 includes the apparatus of example 25, wherein the first layer includes an opening adjacent the printed circuit board and the printed circuit board includes a first heat-generating component extending into the opening.
Example 28 includes the apparatus of example 27, wherein opening is a first opening and further including a second opening defined in the first layer, and the printed circuit board includes a second heat-generating component extending into the second opening.
Example 29 includes the apparatus of example 27, wherein the heat-generating component at least partially abuts the second layer.
Example 30 includes the apparatus of example 25, wherein the first layer and the second layer are coupled via at least one of a friction stir weld or an electron beam weld.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus (100, 400, 500, 602A, 702A, 800, 1900, 1902, 1908, 2000, 2600) comprising:
a first printed circuit board (200);
a second printed circuit board (101, 703A, 802, 2003) coupled to the first printed circuit board (200), the second printed circuit board (101, 703A, 802, 2003) having a first side (102A, 804A, 2020A) and a second side (102B, 804B, 2020B) opposite the first side (102A, 804A, 2020A), the second side (102B, 804B, 2020B) facing the first printed circuit board (200); and
a cold plate (302, 404, 504, 702A, 808, 2004, 2604) coupled to the second side (102B, 804B, 2020B) of the second printed circuit board (101, 703A, 802, 2003).

2. The apparatus (100, 800, 1900, 1902, 1908) of claim 1, further including a stiffener (300, 312, 806, 1904) coupled to the second side (102B, 804B) of the second printed circuit board (101, 802).

3. The apparatus (100) of claim 2, wherein the stiffener (300, 312) includes the cold plate (302, 312).

4. The apparatus (800) of claim 2, wherein the stiffener (806) includes an opening (1204) defined therein and wherein the second printed circuit board (802) includes a heat-producing component (1100) at least partially disposed in the opening (1200).

5. The apparatus (2600) of claim 1, further including a stiffener (2602) including:
a core (2608) composed of a first material; and
a shell (2610) partially encompassing the core (2608), the shell (2610) abutting the printed circuit board (802) and the cold plate (2604), the shell (2610) composed of a second material more thermally conductive the first material.

6. The apparatus (400, 500, 800) of any one of claims 1-5, wherein the cold plate (302, 808) is a first cold plate (302, 808), further including a second cold plate (404, 504, 602A, 702A, 2004) disposed on the first side (102A, 804A) of the second printed circuit board (101, 802).

7. The apparatus (400) of claim 6, wherein the first cold plate (302) includes a first inlet (414) and the second cold plate (404) includes:
a second inlet (406) to be fluidly coupled to a coolant source (710);
a first outlet (408) to be fluidly coupled to the coolant source (710); and
a second outlet (412) fluidly coupled to the first inlet (414).

8. The apparatus (500) of claim 6, wherein the first cold plate (502) and the second cold plate (504) are independently coupled to a coolant source (710).

9. The apparatus (800) of claim 1, further including a stiffener (806) and wherein the cold plate (808) includes:
an inlet (810A);
an outlet (810B);
a housing (1300) defining a cavity (1302), the inlet (810A) and the outlet (810B) defining a coolant pathway in through the cavity (1302); and
a plate (1402) coupled to the housing (1300) and proximate to the stiffener (806).

10. The apparatus (800) of claim 9, wherein the plate (1402) includes a plurality of fins (1406) extending into the cavity (1302).

11. The apparatus (800) of claim 9, wherein the housing (1300) includes a plurality of walls (1604, 1606A, 1606B, 1606C) segmenting the cavity (1302) into a first section (1608A) and a second section (1608B), the coolant pathway (1610A) extending through the first section (1608A) and the second section (1608B).

12. The apparatus (800) of any one of claims 9-11, wherein the housing (1300) and the plate (1702) are integrally formed.

13. The apparatus (800) of any one of claims 9-11, wherein the housing (1300) includes a groove (1304) defined therein and further including a seal (904) disposed in the groove (1304).

14. A method (2700) comprising:
coupling a primary side cooling system (404, 504, 2004, 2202) to a first side (102A, 804A, 2020A, 2304A) of a first printed circuit board ((101, 703A, 802, 2003, 2101A, 2302);
coupling a secondary side cooling system (300, 310, 402, 502, 602B, 702A, 800, 2002, 2102A, 2300, 2602) to a second side (102B, 804B, 2020B, 2304B) of a first printed circuit board (101, 703A, 802, 2003, 2101A, 2302); and
coupling the first printed circuit board (101, 703A, 802, 2003, 2302) to a second printed circuit board (200), the secondary side cooling system (300, 310, 402, 502, 602B, 702A, 800, 2002, 2102A, 2300, 2602) between the first printed circuit board (101, 703A, 802, 2003, 2101A, 2302) and the second printed circuit board (200).

15. The method (2700) of claim 14, wherein the secondary side cooling system (702A) is a first secondary side cooling system (702A), and further including coupling a flow conduit (708) of the first secondary side cooling system (702A) to a second secondary side cooling system (702B) coupled to a third printed circuit board (703B) adjacent to the first printed circuit board (703A).

## Amended claims

### Amended claims in accordance with Rule 137(2) EPC.

1. An apparatus (100, 400, 500, 602A, 702A, 800, 1900, 1902, 1908, 2000, 2600) comprising:
a first printed circuit board (200);
a second printed circuit board (101, 703A, 802, 2003) coupled to the first printed circuit board (200), the second printed circuit board (101, 703A, 802, 2003) having a first side (102A, 804A, 2020A) and a second side (102B, 804B, 2020B) opposite the first side (102A, 804A, 2020A), the second side (102B, 804B, 2020B) facing the first printed circuit board (200);
a cold plate (302, 404, 504, 702A, 808, 2004, 2604) coupled to the second side (102B, 804B, 2020B) of the second printed circuit board (101, 703A, 802, 2003); and
a stiffener (2602) including:
a core (2608) composed of a first material; and
a shell (2610) partially encompassing the core (2608), the shell (2610) abutting the printed circuit board (802) and the cold plate (2604), the shell (2610) composed of a second material more thermally conductive than the first material.

2. The apparatus (100, 800, 1900, 1902, 1908) of claim 1, further including a stiffener (300, 310, 806, 1904) coupled to the second side (102B, 804B) of the second printed circuit board (101, 802).

3. The apparatus (100) of claim 2, wherein the stiffener (300, 310) includes the cold plate (302, 312).

4. The apparatus (800) of claim 2, wherein the stiffener (806) includes an opening (1204) defined therein and wherein the second printed circuit board (802) includes a heat-producing component (1100) at least partially disposed in the opening (1204).

5. The apparatus (400, 500, 800) of any one of claims 1-4, wherein the cold plate (302, 808) is a first cold plate (302, 808), further including a second cold plate (404, 504, 602A, 702A, 2004) disposed on the first side (102A, 804A) of the second printed circuit board (101, 802).

6. The apparatus (400) of claim 5, wherein the first cold plate (402) includes a first inlet (414) and a side outlet (416) and the second cold plate (404) includes:
a second inlet (406) to be fluidly coupled to a coolant source (710);
a first outlet (408) to be fluidly coupled to the coolant source (710); and
a second outlet (412) fluidly coupled to the first inlet (414);
a side inlet (410) to be fluidly coupled to the side outlet (416).

7. The apparatus (500) of claim 5, wherein the first cold plate (502) and the second cold plate (504) are independently coupled to a coolant source (710).

8. The apparatus (800) of claim 1, further including a stiffener (806) and wherein the cold plate (808) includes:
an inlet (810A);
an outlet (810B);
a housing (1300) defining a cavity (1302), the inlet (810A) and the outlet (810B) defining a coolant pathway in through the cavity (1302); and
a plate (1402) coupled to the housing (1300) and proximate to the stiffener (806).

9. The apparatus (800) of claim 8, wherein the plate (1402) includes a plurality of fins (1406) extending into the cavity (1302).

10. The apparatus (800) of claim 8, wherein the housing (1300) includes a plurality of walls (1604, 1606A, 1606B, 1606C) segmenting the cavity (1302) into a first section (1608A) and a second section (1608B), the coolant pathway (1610A) extending through the first section (1608A) and the second section (1608B).

11. The apparatus (800) of any one of claims 8-10, wherein the housing (1300) and the plate (1402) are integrally formed.

12. The apparatus (800) of any one of claims 8-10, wherein the housing (1300) includes a groove (1304) defined therein and further including a seal (904) disposed in the groove (1304).

13. A method (2700) comprising:
coupling a primary side cooling system (404, 504, 2004, 2202) to a first side (102A, 804A, 2020A, 2304A) of a first printed circuit board ((101, 703A, 802, 2003, 2101A, 2302);
coupling a secondary side cooling system (300, 310, 402, 502, 602B, 702A, 800, 2002, 2102A, 2300, 2602) to a second side (102B, 804B, 2020B, 2304B) of a first printed circuit board (101, 703A, 802, 2003, 2101A, 2302);
coupling the first printed circuit board (101, 703A, 802, 2003, 2302) to a second printed circuit board (200), the secondary side cooling system (300, 310, 402, 502, 602B, 702A, 800, 2002, 2102A, 2300, 2602) between the first printed circuit board (101, 703A, 802, 2003, 2101A, 2302) and the second printed circuit board (200); and
providing a stiffener (2602) including:
a core (2608) composed of a first material; and
a shell (2610) partially encompassing the core (2608), the shell (2610) abutting the first printed circuit board (802) and the cold plate (2604), the shell (2610) composed of a second material more thermally conductive the first material.

14. The method (2700) of claim 13, wherein the secondary side cooling system (702A) is a first secondary side cooling system (702A), and further including coupling a flow conduit (708) of the first secondary side cooling system (702A) to a second secondary side cooling system (702B) coupled to a third printed circuit board (703B) adjacent to the first printed circuit board (703A).
